# EUROPEAN PATENT APPLICATION

(11) **EP 4 636 808 A1**
(43) Date of publication of application: **22.10.2025**
(21) Application number: 23903563.7
(22) Date of filing: 14.12.2023
(51) Int. Cl.: H01L 21/02, C09J 11/06, C09J 201/00, H01L 21/56

(54) **PEELING AGENT COMPOSITION FOR PHOTOIRRADIATION-BASED PEELING, LAMINATE, AND METHOD FOR PRODUCING PROCESSED SEMICONDUCTOR SUBSTRATE OR ELECTRONIC DEVICE LAYER**

(30) Priority: 15.12.2022 JP 2022199891
(71) Applicant: Nissan Chemical Corporation, Tokyo 103-6119 (JP)
(72) Inventor: YANAI, Masaki, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/044822
(87) International publication number: WO 2024/128279

(57) **Abstract**

According to the present invention, it is possible to provide a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing, the release agent composition being capable of easily releasing the semiconductor substrate or the electronic device layer from the support substrate only by light irradiation even without heating after light irradiation. A release agent composition for light irradiation release for forming a release agent layer of a laminate which includes a semiconductor substrate or an electronic device layer, a light-transmissive support substrate, and an adhesion layer and a release agent layer provided between the semiconductor substrate or the electronic device layer and the support substrate, in which the electronic device layer includes a plurality of semiconductor chip substrates and a sealing resin disposed between the semiconductor chip substrates, and which is used for releasing the semiconductor substrate or the electronic device layer from the support substrate after the release agent layer absorbs light emitted from the support substrate side, in which the release agent composition is: (i) a composition containing a polymer including a light-sensitive gas generating moiety that generates gas due to a chemical reaction by receiving the light; or (ii) a composition containing a compound including a light-sensitive gas generating moiety that generates gas due to a chemical reaction by receiving the light and a polymer.

## Description

### Technical Field

The present invention relates to a release agent composition for light irradiation release, a laminate, and a method for producing a processed semiconductor substrate or electronic device layer.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technique of integrating layers while connecting them by a through silicon via (TSV). At the time of multi-layer integration, respective wafers to be integrated are thinned by polishing on the side opposite to the formed circuit surface (that is, the back surface), and the thinned semiconductor wafers are laminated.

A pre-thinned semiconductor wafer (also referred to herein simply as a wafer) is adhered to a support in order to be polished with a polishing device. The adhesion at that time needs to be easily released after polishing, and therefore is referred to as temporary adhesion. This temporary adhesion must allow for easy removal from the support. Otherwise, the thinned semiconductor wafer may be cut or deformed when a large force is applied for the removal. The removal is easily performed such that such a situation does not occur. However, at the time of polishing the back surface of a semiconductor wafer, it is not preferable that the semiconductor wafer is detached or displaced due to polishing stress. Therefore, the performance required for temporary adhesion is to withstand the stress during polishing and to allow for easy removal after polishing.

For example, there is a demand for a performance having a high stress (strong adhesive force) in the planar direction at the time of polishing and a low stress (weak adhesion force) in the longitudinal direction at the time of removal.

Although various methods by light irradiation have been reported for such adhesion and separation processes (see, for example, Patent Literatures 1 and 2), new techniques related to release by light irradiation such as an ultraviolet ray are always required with further progress in the recent semiconductor field.

Under such circumstances, as a release layer of a laminate including a semiconductor substrate, a support substrate that transmits ultraviolet rays, and an adhesive layer and a release layer provided between the semiconductor substrate and the support substrate, a laminate formed using a film made from a release agent composition containing a polymer of ethylenically unsaturated monomers containing a tertiary butoxycarbonyl group, a photoacid generator, and a solvent has been provided (see, for example, Patent Literature 3).

In addition, in a method for processing a substrate by temporarily adhering a support, examples of the substrate to be temporarily adhered include an electronic device layer including a plurality of semiconductor chip substrates and a sealing resin disposed between the semiconductor chip substrates, in addition to the semiconductor substrate intended for thinning as described above.

A semiconductor package (electronic component) including a semiconductor element (also referred to as a semiconductor chip substrate) has various forms depending on a corresponding size, and examples thereof include a wafer level package (WLP) and a panel level I package (PLP).

In order to reduce the size of the semiconductor package, it is important to reduce the thickness of the substrate in the element to be incorporated. However, when the thickness of the substrate is reduced, the strength thereof is reduced, and the substrate is likely to be damaged during the semiconductor package production. Meanwhile, a technology is known in which a substrate is temporarily adhered to a support using an adhesive, the substrate is processed, and then the substrate and the support are separated from each other (refer to, for example, Patent Literatures 4 and 5).

### Citation List

### Patent Literature

Patent Literature 1: JP 2004-64040 A
Patent Literature 2: JP 2012-106486 A
Patent Literature 3: WO 2021-256386 A
Patent Literature 4: JP 2019-34541 A
Patent Literature 5: JP 2020-107649 A

### Summary of Invention

### Technical Problem

In the laminate described in Patent Literature 3, in order to release the semiconductor substrate and the support substrate, the release layer needs to be irradiated with UV light and then subjected to a post-heating step.

However, in a case where the semiconductor substrate and the support substrate can be released only by irradiating the release layer with UV light even without a heating step after irradiation, the number of steps can be reduced, which is desirable in terms of production efficiency and cost.

Accordingly, it is desired to provide a laminate having a release agent layer capable of releasing the semiconductor substrate and the support substrate only by light irradiation even without heating after the light irradiation.

In order to make further progress in the recent semiconductor field, a new type of release agent composition to be used is always required to be developed.

The present invention has been made in view of the above circumstances, and an object of the present invention is to provide a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing, the release agent composition being capable of easily releasing the semiconductor substrate or the electronic device layer from the support substrate only by light irradiation even without heating after light irradiation.

### Solution to Problem

As a result of intensive studies to solve the above-mentioned problems, the present inventors found that the above-mentioned problems can be solved, and completed the present invention having the following gist.

That is, the present invention includes the following.
[1] A release agent composition for light irradiation release for forming a release agent layer of a laminate which includes
   a semiconductor substrate or an electronic device layer,
   a light-transmissive support substrate, and
   an adhesion layer and a release agent layer provided between the semiconductor substrate or the electronic device layer and the support substrate,
   wherein the electronic device layer includes a plurality of semiconductor chip substrates and a sealing resin disposed between the semiconductor chip substrates, and
   which is used for releasing the semiconductor substrate or the electronic device layer from the support substrate after the release agent layer absorbs light emitted from the support substrate side,
   wherein the release agent composition is:
      (i) a composition containing a polymer including a light-sensitive gas generating moiety that generates gas due to a chemical reaction by receiving the light; or
      (ii) a composition containing a compound including a light-sensitive gas generating moiety that generates gas due to a chemical reaction by receiving the light and a polymer.
[2] The release agent composition according to [1], wherein the light-sensitive gas generating moiety has a structure selected from the group consisting of a nitrobenzene-based structure, an oxime ester-based structure, an azide-based structure, a diazonium-based structure, a ketoprofen-based structure, a diazonaphthoquinone-based structure, an azo-based structure, an azobis-based structure, a sulfohydrazide-based structure, a hydrazo-based structure, a benzoin carbamate-based structure, a 1,2,3-thiazole-based structure, and a diazomethanesulfonic acid-based structure.
[3] The release agent composition according to [1] or [2], wherein the polymer containing a light-sensitive gas generating moiety has a repeating unit represented by any one of the following Formula (1): 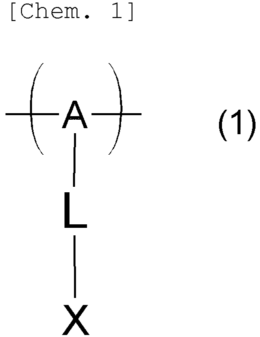 wherein in Formula (1), A represents a trivalent hydrocarbon group, L represents a linking group, and X represents a light-sensitive gas generating moiety.
[4] The release agent composition according to [3], wherein Formula (1) above is a repeating unit represented by any one of the following Formulae (2-1) to (2-3), and the linking group of L is at least one of a single bond, - CO-, -COO-, an alkyl group optionally having a substituent, or -NH-. 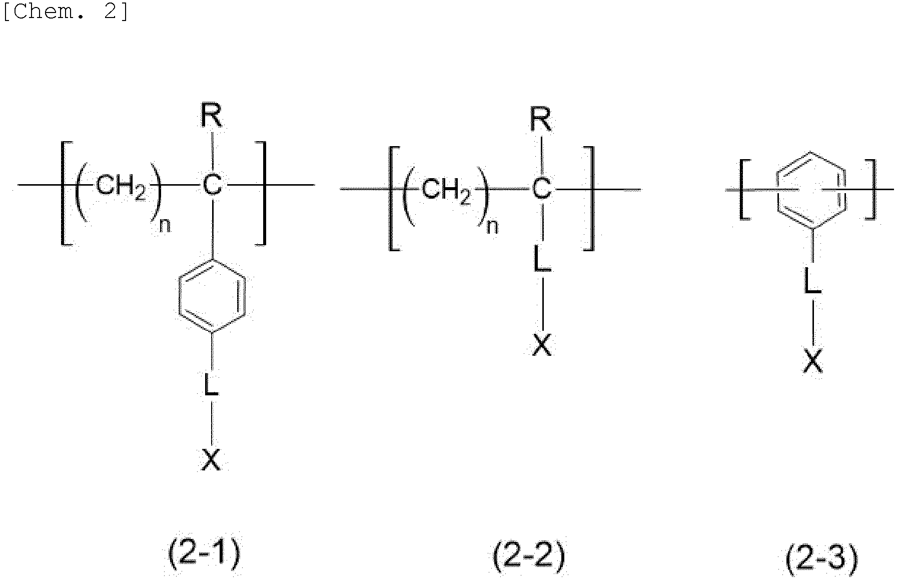 wherein in Formulae (2-1) to (2-3), R represents a hydrogen bond or a methyl group. X represents a light-sensitive gas generating moiety, and n represents an integer of 0 or 1.
[5] The release agent composition according to [3] or [4], wherein in Formula (1) above, the light-sensitive gas generating moiety of X is represented by any one of the following Formulae (3-1) to (3-8): 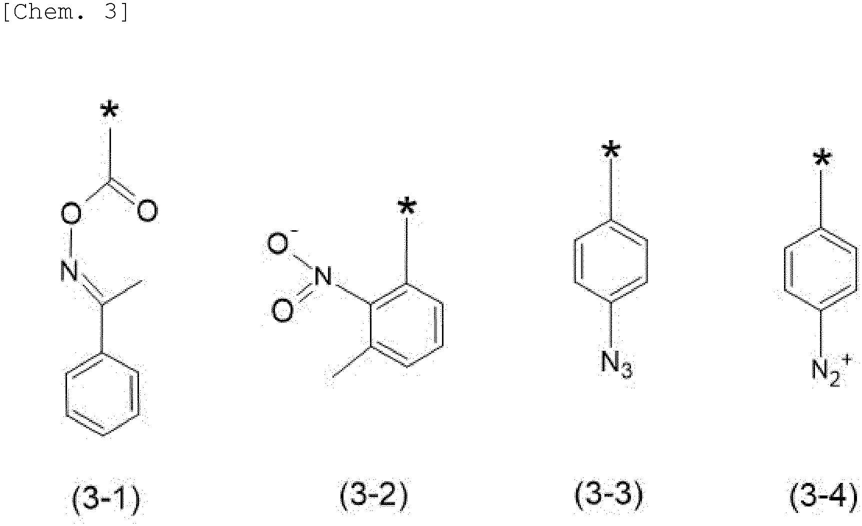 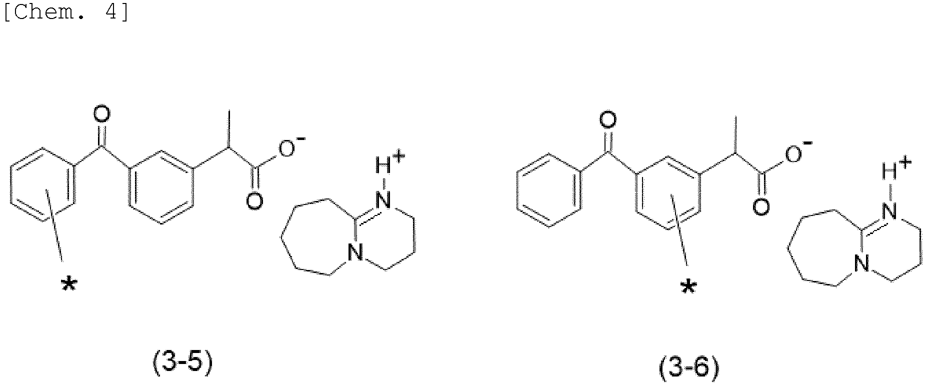 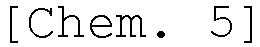 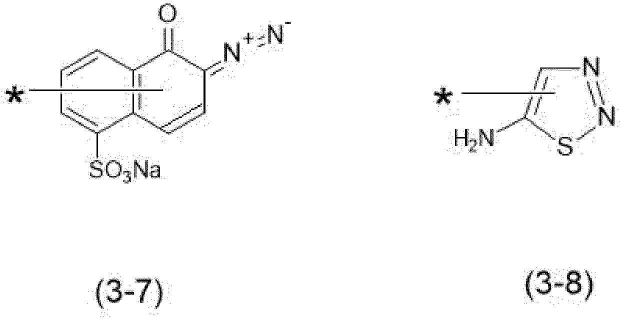 wherein in Formulae (3-1) to (3-8), * represents a bonding hand.
[6] The release agent composition according to [1], wherein the compound containing a light-sensitive gas generating moiety has a compound represented by any one of the following Formulae (4-1) to (4-4): 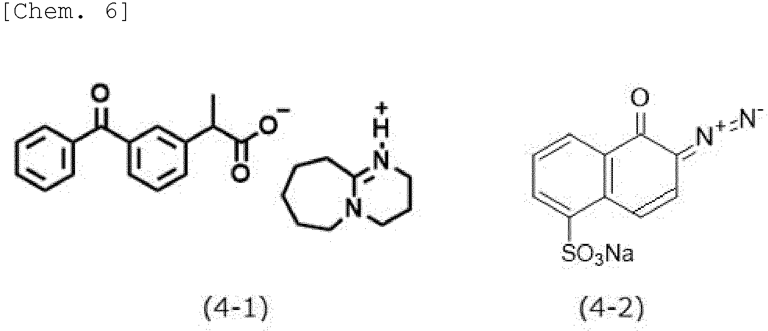 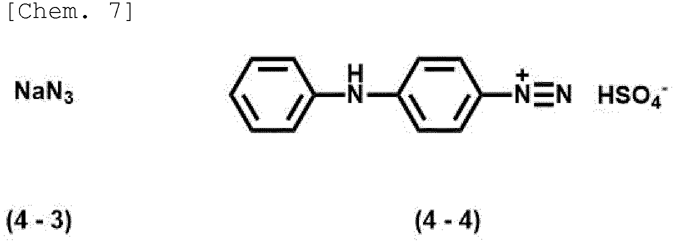
[7] A laminate, including:
   a semiconductor substrate or an electronic device layer;
   a light-transmissive support substrate; and
   an adhesion layer and a release agent layer which are provided between the semiconductor substrate or the electronic device layer and the support substrate,
   wherein the electronic device layer includes a plurality of semiconductor chip substrates and a sealing resin disposed between the semiconductor chip substrates,
   the release agent layer is used to release the semiconductor substrate or the electronic device layer and the support substrate after the release agent layer absorbs light emitted from the support substrate side, and
   the release agent layer is formed from the release agent composition according to any one of [1] to [6].
[8] A method for producing a processed semiconductor substrate or a processed electronic device layer, the method including:
   Step 5A of processing the semiconductor substrate of the laminate according to claim 7, or Step 5B of processing the electronic device layer of the laminate according to claim 7; and
   Step 6A of separating the semiconductor substrate processed in the Step 5A and the support substrate from each other, or Step 6B of separating the electronic device layer processed in the Step 5B and the support substrate from each other.
[9] The method for producing a processed semiconductor substrate or a processed electronic device layer according to [8], wherein the Step 6A or the Step 6B includes a step of irradiating the laminate with UV light from the support substrate side.

### Advantageous Effects of Invention

According to the present invention, it is possible to provide a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing, the release agent composition being capable of easily releasing the semiconductor substrate or the electronic device layer from the support substrate only by light irradiation even without heating after light irradiation.

### Brief Description of Drawings

Fig. 1 is a schematic cross-sectional view of an example of a laminate in a first embodiment.
Fig. 2 is a schematic cross-sectional view of an example of a laminate in a second embodiment.
Fig. 3 is a schematic cross-sectional view for explaining a method for producing the laminate showing an example in the second embodiment.
Fig. 4 is a schematic cross-sectional view for explaining a method for producing the laminate showing an example in the second embodiment.
Fig. 5 is a schematic cross-sectional view for explaining a method for producing a laminate showing an example in the second embodiment.
Fig. 6 is a schematic cross-sectional view for explaining a method for producing the laminate showing an example in the second embodiment.
Fig. 7 is a schematic cross-sectional view for explaining a method for processing the laminate showing an example in the second embodiment.
Fig. 8 is a schematic cross-sectional view for explaining a method for processing the laminate showing an example in the second embodiment.
Fig. 9 is a schematic cross-sectional view for explaining a method for separating the laminate showing an example in the second embodiment.
Fig. 10 is a schematic cross-sectional view for explaining a method for separating the laminate showing an example in the second embodiment.
Fig. 11 is a schematic cross-sectional view for explaining a method for cleaning the laminate showing an example in the second embodiment after the separation.

### Description of Embodiments

### (Release agent composition for light irradiation release)

A release agent composition of the present invention is a composition that can be released by light irradiation.

The release agent composition of the present invention is a composition used for easily releasing a semiconductor substrate or an electronic device layer from a support substrate.

The release agent composition of the present invention contains (i) a composition containing a polymer including a light-sensitive gas generating moiety that generates gas due to a chemical reaction by receiving the light; or (ii) a composition containing a compound including a light-sensitive gas generating moiety that generates gas due to a chemical reaction by receiving the light and a polymer.

The release agent composition of the present invention may contain a solvent and an additional component in addition to the polymer containing a light-sensitive gas generating moiety or the compound containing a light-sensitive gas generating moiety and the polymer.

### <Polymer or compound Including light-sensitive gas generating moiety>

The light-sensitive gas generating moiety contained in the polymer or compound according to the present invention refers to a moiety having a functional group in which a chemical reaction (photolysis) occurs by absorbing light of a specific wavelength such as ultraviolet rays and gas is generated as a result of the chemical reaction (photolysis).

In the release layer of the present invention, gas is generated by light irradiation, as a result of which the semiconductor substrate or the electronic device layer can be easily released from the support substrate.

The light-sensitive gas generating moiety where gas is generated by photolysis has, for example, a structure selected from the group consisting of a nitrobenzene-based structure, an oxime ester-based structure, an azide-based structure, a diazonium-based structure, a ketoprofen-based structure, a diazonaphthoquinone-based structure, an azo-based structure, an azobis-based structure, a sulfohydrazide-based structure, a hydrazo-based structure, a benzoin carbamate-based structure, a 1,2,3-thiazole-based structure, and a diazomethanesulfonic acid-based structure.

Examples of the gas generated by photolysis include carbon dioxide, nitrogen monoxide, nitrogen, carbon monoxide, oxygen, and hydrogen.

As described above, the release agent composition of the present invention is either (i) a composition containing a polymer including a light-sensitive gas generating moiety, or (ii) a composition containing a compound including a light-sensitive gas generating moiety and a polymer. Respective aspects of (i) and (ii) will be described in more detail below.

A preferred embodiment of the release agent composition of the present invention is, for example,

(Embodiment IA) a composition that contains a polymer having a repeating unit represented by the following Formula (1), the polymer including a light-sensitive gas generating moiety, or
(Embodiment IB) a composition that contains a compound including a light-sensitive gas generating moiety and a polymer. 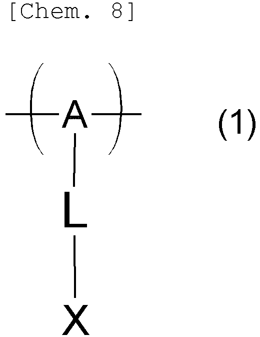 wherein in Formula (1), A represents a trivalent hydrocarbon group, L represents a linking group, and X represents a light-sensitive gas generating moiety.

Therefore, the release agent composition of the present invention containing the polymer having the repeating unit represented by Formula (1) described above which includes a light-sensitive gas generating moiety will be described in the following section of <<Embodiment IA>>.

Meanwhile, the release agent composition of the present invention in which a compound containing a light-sensitive gas generating moiety is contained in a polymer will be described in the following section of <<Embodiment IB>>.

### <<Embodiment IA>>

Preferably, the repeating unit represented by Formula (1) is, for example, a repeating unit represented by any one of the following Formulae (2-1) to (2-3): 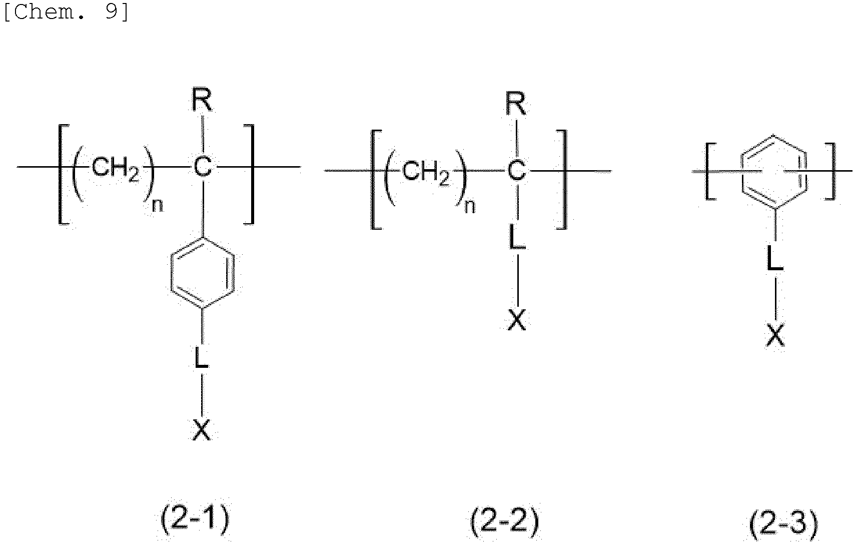 wherein in Formulae (2-1) to (2-3), R represents a hydrogen bond or a methyl group. L represents a linking group, and X represents a light-sensitive gas generating moiety. n represents an integer of 0 or 1.

Preferably, in Formula (1), the linking group of L is, for example, at least one of a single bond, -CO-, - COO-, an alkyl group optionally having a substituent, or - NH-. A plurality of these linking groups may be used in combination.

Here, the substituent that may be substituted with an alkyl group is, for example, -OH.

Preferably, in Formula (1), the light-sensitive gas generating moiety of X is, for example, a moiety represented by any one of the following Formulae (3-1) to (3-8): 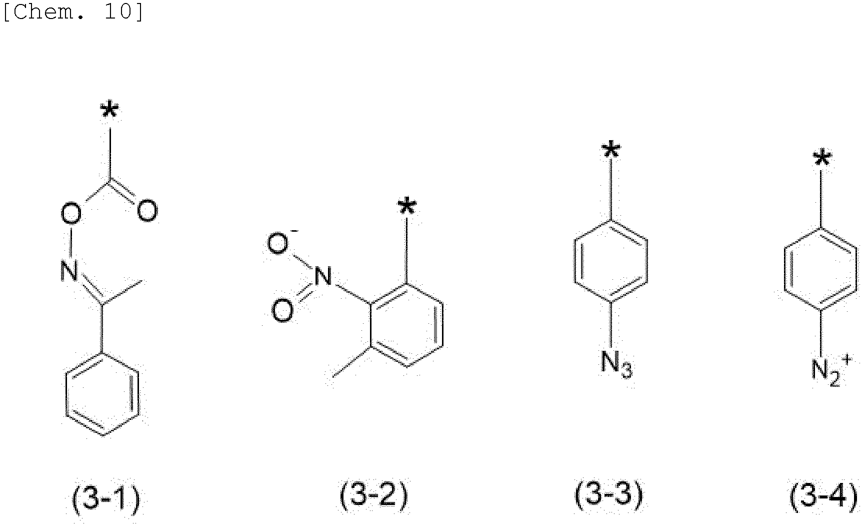 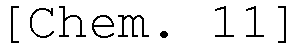 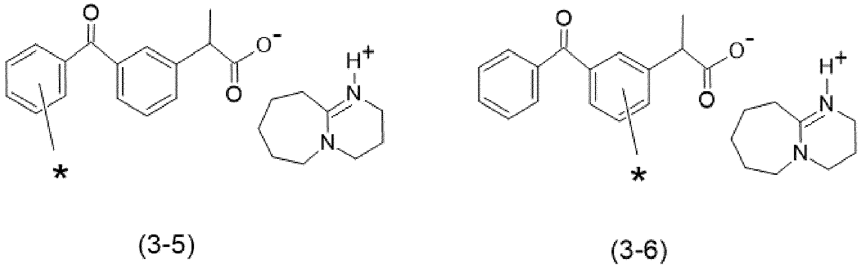 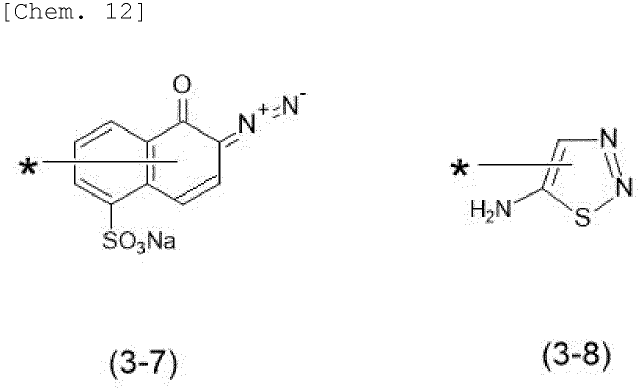 wherein in Formulae (3-1) to (3-8), * represents a bonding hand.

The polymer having a repeating unit represented by Formula (1) containing a light-sensitive gas generating moiety is not particularly limited as long as it is a polymer containing a light-sensitive gas generating moiety where gas is generated by photolysis, and can be appropriately selected according to a purpose. Examples thereof include a polymer having a nitrobenzene-based structure represented by the following Formula (5-1), a polymer having an oxime ester-based structure represented by the following Formula (5-2), a polymer having an azide-based structure represented by the following Formula (5-3), and a polymer having a diazonium-based structure represented by the following Formula (5-4).

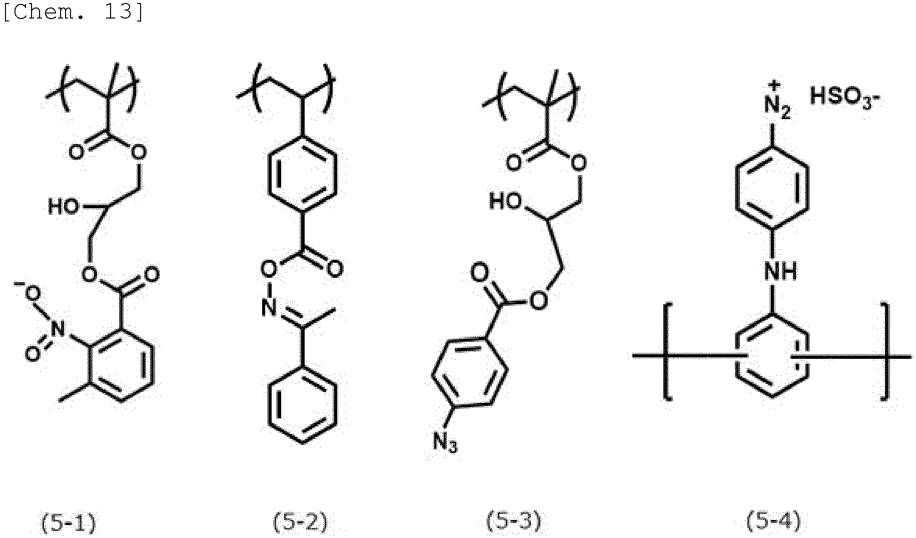

### <<Embodiment IB>>

The release agent composition of Embodiment IB is a composition in an aspect in which a compound having a light-sensitive gas generating moiety is dispersed in a polymer.

The compound having a light-sensitive gas generating moiety to be dispersed in a polymer is not particularly limited as long as it is a compound having a light-sensitive gas generating moiety where gas is generated by photolysis, and can be appropriately selected according to a purpose, and examples thereof include a compound having a ketoprofen-based structure (2-(3-benzoylphenyl)propionic acid) represented by the following Formula (4-1), a compound having a diazonaphthoquinone-based structure represented by the following Formula (4-2), a compound having an azide-based structure represented by the following Formula (4-3), and a compound having a diazonium-based structure represented by the following Formula (4-4).

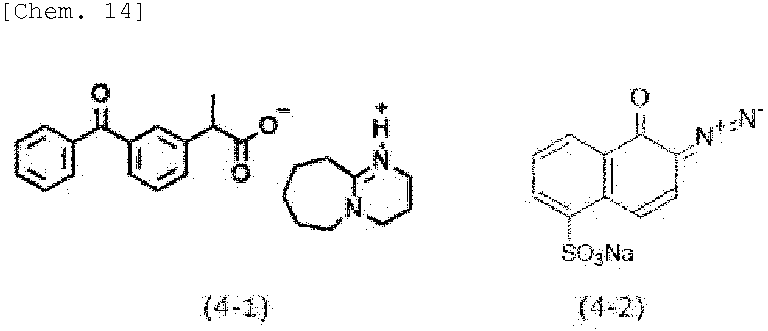

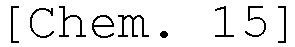

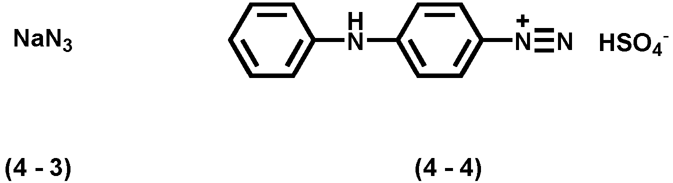

Since a film cannot be formed only by dissolving the compound having a light-sensitive gas generating moiety in a solvent, a film is formed by dispersing the compound having a light-sensitive gas generating moiety in a polymer. Therefore, the polymer that disperses the compound having a light-sensitive gas generating moiety is not particularly limited as long as it contributes to film formation, and can be appropriately selected for any purpose, and examples thereof include resins that can be used as binder resins, such as poly(meth)acrylic acid-based resins, polyolefin-based resins, polystyrene-based resins, polyester-based resins, silicone resins, polyurethane-based resins, polycarbonate-based resins, novolac resins, condensed epoxy-based resins, and polyether-based resins. Among them, from the viewpoint of allowing the semiconductor substrate to be firmly adhered, the polymer is preferably a poly(meth)acrylic acid-based resin having a repeating unit represented by the following Formula (I).

The "(meth)acrylic acid" refers to methacrylic acid and/or acrylic acid.

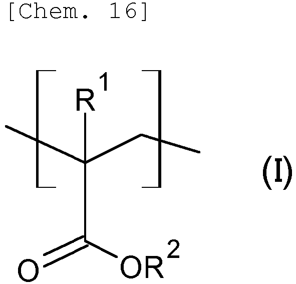

In Formula (I), R¹ represents a hydrogen atom or a methyl group. R² represents a hydrogen atom or a chain saturated hydrocarbon group having 1 to 5 carbon atoms.

Among the poly(meth)acrylic acid-based resins having a repeating unit represented by the above formula (I), preferred embodiments include polyacrylic acid having a repeating unit represented by the following formula (I-1) and polymethylmethacrylate having a repeating unit represented by the following formula (I-2).

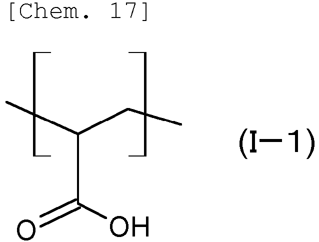

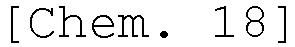

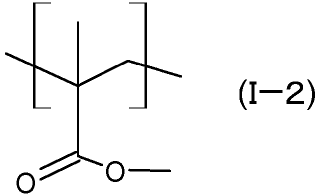

### <Additional Component>

The release agent composition of the present invention can also contain a solvent.

As the solvent, for example, an organic solvent can be used.

Specific examples of the organic solvent include, but are not limited to, aliphatic hydrocarbons, aromatic hydrocarbons, and ketones.

More specific examples of the organic solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone.

Additional examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether (PGME), propylene glycol monomethyl ether acetate (PGMEA), propylene glycol monoethyl ether, propylene glycol monoethyl ether acetate, propylene glycol propyl ether acetate, toluene, xylene, methyl ethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, and butyl lactate.

The release agent composition of the present invention can also contain a photosensitizer.

Examples of the photosensitizer include acenaphthene, 2,3-benzofluorene, 2,4,5,6-dibenzophenanthrene, 1,2-benzanthracene, perylene, picramide, 2,6-dichloro-4-nitroaniline, 5-nitroacenaphthene, 1-nitro-4-dimethylaminonaphthalene, 2-nitrofluorene, 2-ethyl anthraquinone, 1,2-benzoanthraquinone, 2,4-diethylthioxanthone, benzanthrone, p,p-tetraethyldiaminobenzophenone, acridine yellow, acridine orange, eosin, erythrosine, rose bengal, chlorophyll, and phthalocyanine, but are not limited thereto.

### <<Preparation of release agent composition>>

The release agent composition of the present invention can be prepared by mixing the polymer containing a light-sensitive gas generating moiety or the compound containing a light-sensitive gas generating moiety and the polymer with a solvent as appropriate if necessary.

In the case of Embodiment IA, in order to obtain the polymer including a light-sensitive gas generating moiety, for example, in Formula (1) above, a polymer component (alternatively, a monomer component for forming the polymer component) for forming an A moiety (which may include an L moiety) and a compound for forming an X moiety (light-sensitive gas generating moiety) can be reacted at a mass ratio of 1 : 2 to 1 : 1.1.

The compounding ratio of the polymer containing a light-sensitive gas generating moiety and the solvent in the case of Embodiment IA is not particularly limited as long as the effect of the present invention is exhibited, and can be appropriately selected for any purpose. For example, the ratio of the polymer containing a light-sensitive gas generating moiety : the solvent is preferably 1 : 2 to 1 : 10, more preferably 1 : 2 to 1 : 5 in terms of mass ratio.

In the case of Embodiment IB, in order to obtain the release agent composition, the compound containing a light-sensitive gas generating moiety and the polymer are mixed, and for example, the mixing ratio of the compound containing a light-sensitive gas generating moiety and the polymer is preferably 1 : 0.2 to 1 : 0.5 in terms of mass ratio.

The compounding ratio of the compound containing a light-sensitive gas generating moiety, the polymer, and the solvent in the case of Embodiment IB is not particularly limited as long as the effect of the present invention is exhibited, and can be appropriately selected for any purpose. For example, the ratio of the compound containing a light-sensitive gas generating moiety : the polymer : the solvent is preferably 1 : 2 to 1 :10, more preferably 1 : 2 to 1 : 5 in terms of a mass ratio.

### (Laminate)

The laminate according to the present invention includes a semiconductor substrate or an electronic device layer, a support substrate, a release agent layer for light irradiation release, and an adhesion layer.

The support substrate has light transmittivity.

The release agent layer for light irradiation release is provided between the semiconductor substrate or the electronic device layer and the support substrate.

The adhesion layer is provided between the semiconductor substrate or the electronic device layer and the support substrate.

The laminate is used for release of the semiconductor substrate or the electronic device layer from the support substrate after the release agent layer absorbs light emitted from the support substrate side.

The release agent layer for light irradiation release is a layer formed of the release agent composition for light irradiation release of the present invention described above.

The laminate of the present invention is used for temporary adhesion in order to process the semiconductor substrate or the electronic device layer, and can be suitably used for processing such as thinning of the semiconductor substrate or the electronic device layer.

While the semiconductor substrate is subjected to processing such as thinning, the semiconductor substrate is supported on the support substrate via the adhesion layer. Meanwhile, after the processing of the semiconductor substrate, the release agent layer is irradiated with light, and thereafter, the support substrate and the semiconductor substrate are separated from each other. Due to a polymer or a compound containing a specific light-sensitive gas generating moiety contained in the release agent composition, in the release agent layer formed from the release agent composition, the specific light-sensitive gas generating moiety absorbs light (e.g. UV light) to cause a chemical reaction and generate gas. As a result, after the release agent layer is irradiated with light, the semiconductor substrate is easily released from the support substrate.

In addition, while the electronic device layer is subjected to processing such as thinning, the electronic device layer is supported on the support substrate via the adhesion layer. Meanwhile, after the processing of the electronic device layer, the release agent layer is irradiated with light, and thereafter, the support substrate and the semiconductor substrate are separated from each other.

Owing to the release agent layer according to the present invention, the semiconductor substrate or the electronic device layer is easily released from the support substrate after being irradiated with light. Furthermore, after the semiconductor substrate or the electronic device layer is released from the support substrate, residues of the release agent layer or the adhesion layer remaining on the semiconductor substrate, the electronic device layer, or the support substrate can be removed by, for example, a cleaning agent composition for cleaning the semiconductor substrate and the like.

The wavelength of light used for release is preferably, for example, a wavelength of 250 to 600 nm, more preferably a wavelength of 250 to 370 nm. The wavelength is more suitably 254 nm, 308 nm, 343 nm, 355 nm, 365 nm, or 532 nm, particularly preferably 254 nm or 365 nm. The irradiation level required for release is a dose capable of causing suitable alteration, for example, decomposition of a specific light-absorbing compound.

The release layer is not necessarily irradiated with light over the entire region of the release layer. Even when the region irradiated with light and the region not irradiated with light are mixed, the semiconductor substrate and the support substrate can be separated from each other by a slight external force such as pulling up of the support substrate as long as the release layer as a whole has sufficiently improved releasing ability.

The light used for release may be laser light or non-laser light emitted from a light source such as an ultraviolet lamp. In the present invention, non-laser light emitted from a light source such as an ultraviolet lamp is preferably used.

The use of non-laser light makes it possible not only to avoid damage on a semiconductor substrate such as a silicon wafer, which is concerned by release by a laser having high energy, but also to shorten the light irradiation time per laminate as compared with the case of using laser light. As a result, it is possible to expect an improvement in throughput. In addition, in the case of using non-laser light, polymer degradation products such as carbides are not generated as compared with the case of using laser light, and thus it is expected that cleaning after release is facilitated.

Hereinafter, a case where the laminate includes a semiconductor substrate and a case where the laminate includes an electronic device layer will be described in detail separately.

The case where the laminate includes a semiconductor substrate will be described in the following <First embodiment>, and the case where the laminate includes an electronic device layer will be described in the following

### <Second embodiment>.

### <First embodiment>

The laminate having a semiconductor substrate is used for processing a semiconductor substrate. While the semiconductor substrate is processed, the semiconductor substrate is adhered to the support substrate via the adhesion layer. After processing the semiconductor substrate, the release agent layer is irradiated with light, and then the semiconductor substrate is separated from the support substrate.

### <<Semiconductor substrate>>

The main material constituting the entire semiconductor substrate is not particularly limited as long as the material is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is ordinarily formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a printed bump, a stud bump, and a plated bump.

Ordinarily, the height, radius, and pitch of the bump are appropriately determined from the conditions of a bump height of approximately 1 to 200 µm, a bump radius of 1 to 200 µm, and a bump pitch of 1 to 500 µm.

Examples of the material of the bump include low melting point solder, high melting point solder, tin, indium, gold, silver, and copper. The bump may be composed of only a single component or may be composed of a plurality of components. More specific examples thereof include alloy plate mainly containing Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

### <<Support substrate>>

The support substrate is not particularly limited as long as it is a member that is light-transmissive to light emitted to the adhesion layer and can support the semiconductor substrate when the semiconductor substrate is processed, and examples thereof include a glass support substrate.

The shape of the support substrate is not particularly limited, and examples thereof include a disk shape.

The thickness of the disk-shaped support substrate may be appropriately determined depending on the size of the semiconductor substrate and the like, and is not particularly limited, but is, for example, 500 to 1,000 µm.

The diameter of the disk-shaped support substrate may be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 µm.

### <<Release agent layer>>

The release agent layer is a layer formed of a release agent composition.

The release agent layer is provided between the semiconductor substrate and the support substrate.

The release agent layer may be in contact with the support substrate or may be in contact with the semiconductor substrate.

The release agent layer is formed using the release agent composition for light irradiation release of the present invention described above.

The release agent composition of the present invention can be suitably used for forming the release agent layer of a laminate including a semiconductor substrate, a support substrate, and a release agent layer provided between the semiconductor substrate and the support substrate. The laminate is used for release of the semiconductor substrate from the support substrate after the release agent layer absorbs light emitted from the support substrate side.

One of the characteristics of the release agent layer obtained from the release agent composition of the present invention is that the semiconductor substrate can be easily released from the support substrate after light irradiation.

In forming the release agent layer from the release agent composition, as long as the effect of the present invention is obtained, the compound having a specific light-sensitive gas generating moiety may be crosslinked by itself or react with an additional component to form a crosslinked structure, or may maintain the structure without crosslinking or reacting.

In other words, in the release agent layer, the compound having a specific light-sensitive gas generating moiety may be crosslinked by itself or react with additional components to form a crosslinked structure, or may exist while maintaining the structure.

The thickness of the release agent layer is not particularly limited, and is ordinarily 0.01 to 20 µm, and is preferably 0.05 µm or more, more preferably 0.1 µm or more, and still more preferably 0.2 µm or more, from the viewpoint of maintaining the film strength, and is preferably 15 µm or less, more preferably 10 µm or less, still more preferably 8 µm or less, and yet still more preferably 5 µm or less, from the viewpoint of avoiding non-uniformity caused by a thick film.

The method for forming the release agent layer from the release agent composition will be described in detail in the description of <<Method for producing one example of laminate in first embodiment>> described below.

### <<Adhesion layer>>

The adhesion layer is provided between the support substrate and the semiconductor substrate.

The adhesion layer is in contact with, for example, the semiconductor substrate. The adhesion layer may be in contact with, for example, the support substrate.

The adhesion layer is not particularly limited, but is preferably a layer formed of an adhesive composition.

### <<Adhesive composition>>

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenolic resin-based adhesive.

Among them, a polysiloxane-based adhesive is preferable as the adhesive composition because the adhesive composition exhibits suitable adhesive ability during processing of the semiconductor substrate or the like, can be suitably released after processing, is further excellent in heat resistance, and can be suitably removed by the cleaning agent composition.

In a preferred aspect, the adhesive composition contains a polyorganosiloxane.

In another preferred aspect, the adhesive composition contains a component that cures by a hydrosilylation reaction.

For example, the adhesive composition used in the present invention contains a curable component (A) to be an adhesive component. The adhesive composition used in the present invention may contain a component (A) to be cured to be an adhesive component and a component (B) that does not cause a curing reaction. Here, examples of the component (B) that does not cause a curing reaction include a polyorganosiloxane. Note that in the present invention, the wording "does not cause a curing reaction" does not mean not causing any curing reaction, but means not causing a curing reaction occurring in the curable component (A).

In a preferred aspect, the component (A) may be a component to be cured by a hydrosilylation reaction or a polyorganosiloxane component (A') to be cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms may be optionally substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') to be cured by a hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2), wherein the polysiloxane (A1) includes: a polyorganosiloxane (a1') containing one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, and also containing at least one selected from the group consisting of the M' unit, the D' unit, and the T' unit; and a polyorganosiloxane (a2') containing one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of the M" unit, the D" unit, and the T" unit.

Note that (al') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, provided that at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an optionally substituted alkyl group or a hydrogen atom, provided that at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is ordinarily 1 to 40, preferably 30 or less, more preferably 20 or less, and still more preferably 10 or less.

Specific examples of the optionally substituted linear or branched alkyl group include a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto, and the number of carbon atoms thereof is ordinarily 1 to 14, preferably 1 to 10, and more preferably 1 to 6. Among them, a methyl group is particularly preferable.

Specific examples of the optionally substituted cyclic alkyl group include a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, but are not limited thereto, and the number of carbon atoms thereof is ordinarily 3 to 14, preferably 4 to 10, and more preferably 5 to 6.

The alkenyl group may be a linear or branched alkenyl group, and the number of carbon atoms thereof is not particularly limited, and is ordinarily 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group. The number of carbon atoms thereof is ordinarily 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is ordinarily 4 to 14, preferably 5 to 10, and more preferably 5 to 6.

As described above, the polysiloxane (A1) contains a polyorganosiloxane (al') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferred combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms of the polyorganosiloxane, and the proportion of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms of the polyorganosiloxane, and the proportion of hydrogen atoms in all substituents and substitutional atoms represented by R¹" to R⁶" is preferably 0.1 to 50.0 mol%, more preferably 10.0 to 40.0 mol%, and the remaining R¹" to R⁶" can be alkyl groups.

When the component (A) contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0 : 0.5 to 1.0 : 0.66.

The weight-average molecular weight of the polysiloxane such as the polyorganosiloxane (a1) or the polyorganosiloxane (a2) is not particularly limited, but each is ordinarily 500 to 1,000,000, and is preferably 5,000 to 50,000 from the viewpoint of achieving the effects of the present invention with good reproducibility.

Note that in the present invention, the weight-average molecular weight, the number average molecular weight, and the dispersity of the polyorganosiloxane (excluding the organosiloxane polymer) can be measured, for example, using a GPC apparatus (EcoSEC, HLC-8320GPC manufactured by Tosoh Corporation) and a GPC column (TSKgel SuperMultiporeHZ-N and TSKgel SuperMultiporeHZ-H manufactured by Tosoh Corporation), at a column temperature of 40°C, using tetrahydrofuran as an eluent (elution solvent), at a flow rate of 0.35 mL/min, and using polystyrene (Shodex manufactured by Showa Denko K.K.) as a standard sample.

The viscosity of each of the polyorganosiloxane (a1) and the polyorganosiloxane (a2) is not particularly limited, and is ordinarily 10 to 1,000,000 (mPa·s), and is preferably 50 to 10000 (mPa·s) from the viewpoint of realizing the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, platinum(II) chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, and is ordinarily in a range of 1.0 to 50.0 ppm relative to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as the polymerization inhibitor can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, and is ordinarily 1,000.0 ppm or more relative to the total amount of the polyorganosiloxane (a1) and the polyorganosiloxane (a2) from the viewpoint of achieving the effect, and is 10,000.0 ppm or less from the viewpoint of preventing excessive suppression of the hydrosilylation reaction.

An example of the adhesive composition used in the present invention may include the component (A) that cures and the component (B) that does not cause a curing reaction to be a release agent component. By including such a component (B) in the adhesive composition, the obtained adhesion layer can be suitably released with good reproducibility.

Typical examples of the component (B) include a non-curable polyorganosiloxane, and specific examples thereof include, but are not limited to, an epoxy group-containing polyorganosiloxane, a methyl group-containing polyorganosiloxane, and a phenyl group-containing polyorganosiloxane.

Examples of the component (B) include polydimethylsiloxane. The polydimethylsiloxane may be modified. Examples of the optionally modified polydimethylsiloxane include, but are not limited to, an epoxy group-containing polydimethylsiloxane, an unmodified polydimethylsiloxane, or a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

The weight-average molecular weight of the polyorganosiloxane as the component (B) is not particularly limited, but is ordinarily 100,000 to 2,000,000, and is preferably 200,000 to 1,200,000, more preferably 300,000 to 900,000 from the viewpoint of realizing the effects of the present invention with good reproducibility. In addition, the dispersity is not particularly limited, and is ordinarily 1.0 to 10.0, and is preferably 1.5 to 5.0, more preferably 2.0 to 3.0 from the viewpoint of, for example, achieving suitable release with good reproducibility. Note that the weight-average molecular weight and the dispersity can be measured by the above-described method related to the polyorganosiloxane.

The viscosity of the polyorganosiloxane as the component (B) is not particularly limited, and is ordinarily 1,000 to 2,000,000 mm²/s. Note that the value of the viscosity of the polyorganosiloxane as the component (B) is expressed by kinematic viscosity, and centistokes (cSt) = mm²/s. The value can also be determined by dividing the viscosity (mPa·s) by the density (g/cm³). That is, the value can be determined from the viscosity and density measured with an E-type rotational viscometer at 25°C, and can be calculated from the equation: kinematic viscosity (mm²/s) = viscosity (mPa·s) /density (g/cm³).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group can include the above-described examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane may include, but are not limited to, an epoxy group-containing polydimethylsiloxane.

The epoxy group-containing polyorganosiloxane contains the above-described siloxane unit (D¹⁰ unit), but may contain, in addition to the D¹⁰ unit, a Q unit, an M unit, and/or a T unit.

In a preferred aspect of the present invention, specific examples of the epoxy group-containing polyorganosiloxane include a polyorganosiloxane composed only of D¹⁰ units, a polyorganosiloxane containing D¹⁰ units and Q units, a polyorganosiloxane containing D¹⁰ units and M units, a polyorganosiloxane containing D¹⁰ units and T units, a polyorganosiloxane containing D¹⁰ units, Q units, and M units, a polyorganosiloxane containing D¹⁰ units, M units, and T units, or a polyorganosiloxane containing D¹⁰ units, Q units, M units, and T units.

The epoxy group-containing polyorganosiloxane is preferably an epoxy group-containing polydimethylsiloxane having an epoxy value of 0.1 to 5. In addition, the weight-average molecular weight thereof is not particularly limited, and is ordinarily 1,500 to 500,000, and is preferably 100,000 or less from the viewpoint of suppressing precipitation in the composition.

Specific examples of the epoxy group-containing polyorganosiloxane include, but are not limited to, those represented by the formulas (E1) to (E3). 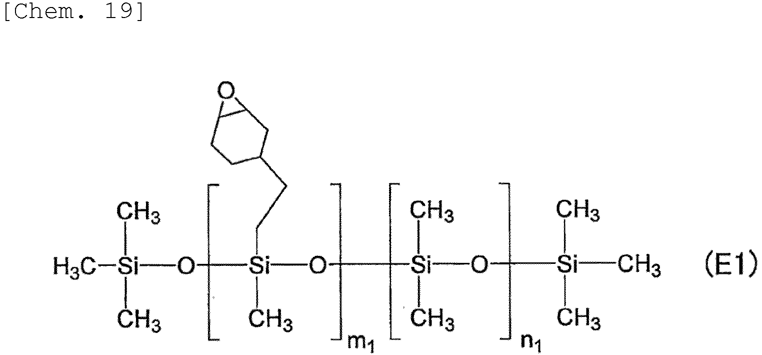 m₁ and n₁ represent the number of respective repeating units, and are positive integers. 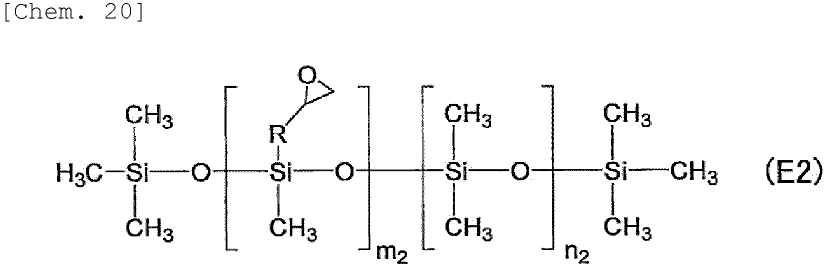 m₂ and n₂ each represent the number of repeating units and are positive integers, and R is an alkylene group having 1 to 10 carbon atoms.

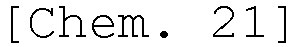

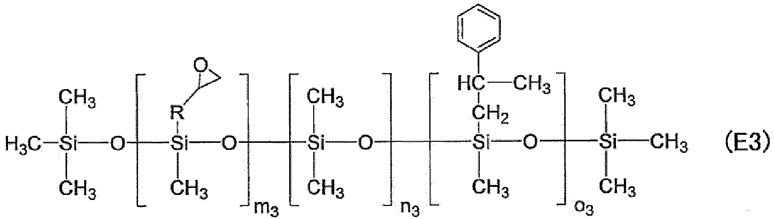

m₃, n₃, and o₃ each represent the number of repeating units and are positive integers, and R is an alkylene group having 1 to 10 carbon atoms.

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to silicon atoms, and each independently represent an alkyl group, provided that at least one of R²¹⁰ and R²²⁰ is a methyl group, and specific examples of the alkyl group may include the above-described examples.

R²¹ is a group bonded to a silicon atom and represents an alkyl group, and specific examples of the alkyl group may include the above-described examples. Among them, a methyl group is preferable as R²¹.

In the present invention, preferred examples of the methyl group-containing polyorganosiloxane may include, but are not limited to, a polydimethylsiloxane.

The methyl group-containing polyorganosiloxane contains the above-described siloxane unit (D²⁰⁰ unit or D²⁰ unit), but may contain, in addition to the D²⁰⁰ unit and the D²⁰ unit, a Q unit, an M unit, and/or a T unit.

In an aspect of the present invention, specific examples of the methyl group-containing polyorganosiloxane include a polyorganosiloxane composed only of D²⁰⁰ units, a polyorganosiloxane containing D²⁰⁰ units and Q units, a polyorganosiloxane containing D²⁰⁰ units and M units, a polyorganosiloxane containing D²⁰⁰ units and T units, a polyorganosiloxane containing D²⁰⁰ units, Q units, and M units, a polyorganosiloxane containing D²⁰⁰ units, M units, and T units, or a polyorganosiloxane containing D²⁰⁰ units, Q units, M units, and T units.

In a preferred aspect of the present invention, specific examples of the methyl group-containing polyorganosiloxane include a polyorganosiloxane composed only of D²⁰ units, a polyorganosiloxane containing D²⁰ units and Q units, a polyorganosiloxane containing D²⁰ units and M units, a polyorganosiloxane containing D²⁰ units and T units, a polyorganosiloxane containing D²⁰ units, Q units, and M units, a polyorganosiloxane containing D²⁰ units, M units, and T units, or a polyorganosiloxane containing D²⁰ units, Q units, M units, and T units.

Specific examples of the methyl group-containing polyorganosiloxane include, but are not limited to, those represented by the formula (M1).

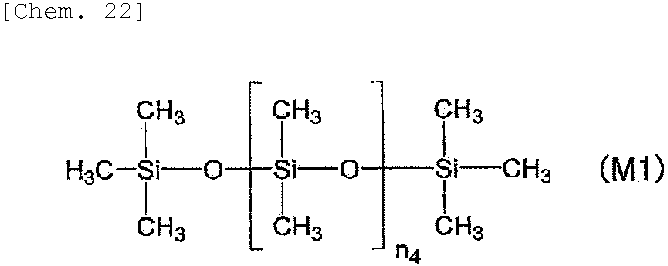

n₄ represents the number of repeating units, and is a positive integer.

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group may include the above-described examples, but a methyl group is preferable.

The phenyl group-containing polyorganosiloxane contains the above-described siloxane unit (D³⁰ unit), but may contain, in addition to the D³⁰ unit, a Q unit, an M unit, and/or a T unit.

In a preferred aspect of the present invention, specific examples of the phenyl group-containing polyorganosiloxane include a polyorganosiloxane composed only of D³⁰ units, a polyorganosiloxane containing D³⁰ units and Q units, a polyorganosiloxane containing D³⁰ units and M units, a polyorganosiloxane containing D³⁰ units and T units, a polyorganosiloxane containing D³⁰ units, Q units, and M units, a polyorganosiloxane containing D³⁰ units, M units, and T units, or a polyorganosiloxane containing D³⁰ units, Q units, M units, and T units.

Specific examples of the phenyl group-containing polyorganosiloxane include, but are not limited to, those represented by the formula (P1) or (P2).

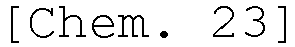

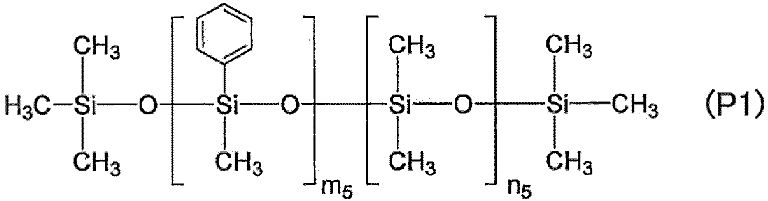

m₅ and n₅ represent the number of respective repeating units, and are positive integers.

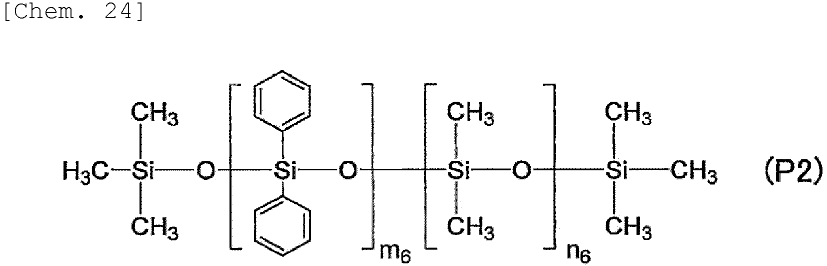

m₆ and n₆ represent the number of respective repeating units, and are positive integers.

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) and the component (B) is preferably 99.995 : 0.005 to 30 : 70, more preferably 99.9 : 0.1 to 75 : 25 in mass ratio [(A) : (B)].

That is, when the polyorganosiloxane component (A') cured by a hydrosilylation reaction is contained, the ratio of the component (A') and the component (B) is preferably 99.995 : 0.005 to 30 : 70, more preferably 99.9 : 0.1 to 75 : 25 in mass ratio [(A') : (B)].

The viscosity of the adhesive composition used in the present invention is not particularly limited, but is ordinarily 500 to 20,000 mPa·s, preferably 1,000 to 10,000 mPa·s at 25°C.

An example of the adhesive composition used in the present invention can be produced by mixing the component (A) and the component (B) when used with a solvent.

The mixing order is not particularly limited, but examples of the method for easily and reproducibly producing the adhesive composition include, but are not limited to, a method in which the component (A) and the component (B) are dissolved in a solvent, and a method in which a part of the component (A) and the component (B) is dissolved in a solvent, the rest is dissolved in a solvent, and the obtained solution is mixed. Note that when the adhesive composition is prepared, the components may be heated, as appropriate, as long as the components are not decomposed or altered.

In the present invention, for the purpose of removing foreign matter, a solvent, a solution, or the like to be used may be filtered using a filter or the like during the production of the adhesive composition or after mixing all the components.

The thickness of the adhesion layer included in the laminate of the present invention is not particularly limited, and is ordinarily 5 to 500 µm, and is preferably 10 µm or more, more preferably 20 µm or more, and still more preferably 30 µm or more, from the viewpoint of maintaining the film strength, and is preferably 200 µm or less, more preferably 150 µm or less, still more preferably 120 µm or less, and yet still more preferably 70 µm or less, from the viewpoint of avoiding non-uniformity caused by a thick film.

The method for forming the adhesion layer from the adhesive composition will be described in detail in the description of <<Method for producing one example of laminate in first embodiment>> described below.

Hereinafter, an example of the configuration of the laminate of the first embodiment will be described with reference to the drawings.

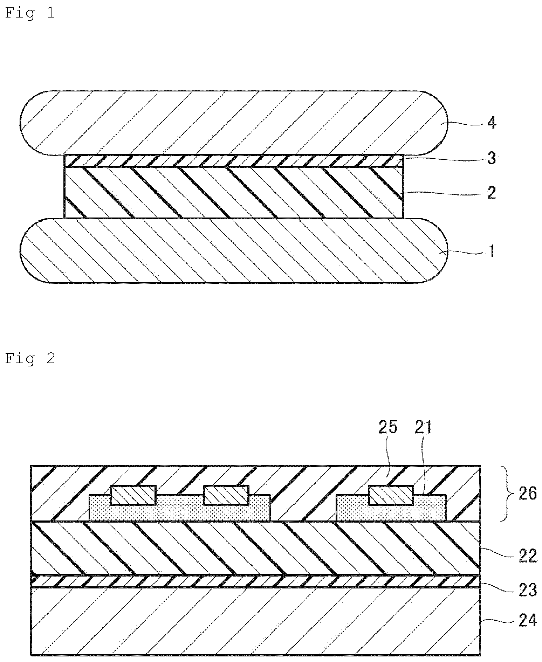

Fig. 1 shows a schematic cross-sectional view of an example of the laminate of the first embodiment.

The laminate of Fig. 1 includes a semiconductor substrate 1, an adhesion layer 2, a release agent layer 3, and a support substrate 4 in this order.

The adhesion layer 2 and the release agent layer 3 are provided between the semiconductor substrate 1 and the support substrate 4. The adhesion layer 2 is in contact with the semiconductor substrate 1. The release agent layer 3 is in contact with the adhesion layer 2 and the support substrate 4.

### <<Method for producing one example of laminate in first embodiment>>

A method for producing a laminate will be described below with the laminate shown in Fig. 1 as an example of the laminate in the first embodiment.

The laminate of the present invention can be produced, for example, by a method including a first step of coating a surface of a semiconductor substrate with an adhesive composition and, if necessary, heating the adhesive composition to form an adhesive coating layer, a second step of coating a surface of a support substrate with a release agent composition and, if necessary, heating the release agent composition to form a release agent coating layer, and a third step of bringing the adhesive coating layer of the semiconductor substrate and the release agent coating layer of the support substrate into close contact with each other by applying a load in the thickness direction of the semiconductor substrate and the support substrate while performing at least one of heat treatment and decompression treatment, and then performing post-heat treatment to form a laminate.

Note that, in Fig. 1, in the laminate, the semiconductor substrate 1, the adhesion layer 2, the release agent layer 3, and the support substrate 4 are stacked in this order, and thus the above-described production method has been exemplified. However, for example, when producing the laminate in which the semiconductor substrate 1, the release agent layer 3, the adhesion layer 2, and the support substrate 4 are stacked in this order, the laminate can be produced by a method including a first step of coating a surface of a semiconductor substrate with a release agent composition and, if necessary, heating the release agent composition to form a release agent coating layer, a second step of coating a surface of a support substrate with an adhesive composition and, if necessary, heating the adhesive composition to form an adhesive coating layer, and a third step of bringing the release agent coating layer of the semiconductor substrate and the adhesive coating layer of the support substrate into close contact with each other by applying a load in the thickness direction of the semiconductor substrate and the support substrate while performing at least one of heat treatment and decompression treatment, and then performing post-heat treatment to form a laminate.

Note that as long as the effect of the present invention is not impaired, application and heating of each composition may be sequentially performed on any one of the substrates.

The application method is not particularly limited, and is ordinarily a spin coating method. Note that it is possible to adopt a method of separately forming a coating film by a spin coating method or the like and attaching the sheet-like coating film as an adhesive coating layer.

The heating temperature of the applied adhesive composition varies depending on the type and amount of the adhesive component contained in the adhesive composition, whether or not a solvent is contained, the boiling point of the solvent used, the desired thickness of the adhesion layer, and the like, and thus cannot be generally specified. The heating temperature is ordinarily 80 to 150°C, and the heating time is ordinarily 30 seconds to 5 minutes.

When the adhesive composition contains a solvent, the applied adhesive composition is ordinarily heated.

The heating temperature of the applied release agent composition varies depending on the type and amount of the release agent component contained in the release agent composition, the desired thickness of the release agent layer, and the like, and thus cannot be generally specified, but from the viewpoint of achieving a suitable release agent layer with good reproducibility, the heating temperature is 80°C or more and 300°C or less, and the heating time is ordinarily determined as appropriate in the range of 10 seconds to 10 minutes depending on the heating temperature. The heating temperature is preferably 100°C or higher and 280°C or lower, more preferably 150°C or higher and 250°C or lower. The heating time is preferably 30 seconds or more and 8 minutes or less, more preferably 1 minute or more and 5 minutes or less.

The heating can be performed using a hot plate, an oven, or the like.

The film thickness of the adhesive coating layer obtained by applying the adhesive composition and heating the adhesive composition as necessary is appropriately determined so as to finally fall within the range of the thickness of the adhesion layer described above.

The film thickness of a release agent coating layer obtained by applying a release agent composition and heating the release agent composition as necessary is finally determined as appropriate to fall within the above-described range of the thickness of the release agent layer.

In the present invention, the laminate of the present invention can be obtained by combining such coating layers to be in contact with each other, bringing the two layers into close contact with each other by applying a load in the thickness direction of the semiconductor substrate and the support substrate while performing heat treatment or decompression treatment or both thereof, and then performing post-heat treatment. Note that which treatment condition of heat treatment, decompression treatment, and combination use of both is adopted is appropriately determined in consideration of various circumstances such as the type of the adhesive composition, the specific composition of the release agent composition, the compatibility of films obtained from both compositions, the film thickness, and the required adhesive strength.

The heat treatment is ordinarily determined as appropriate from the range of 20 to 150°C from the viewpoint of removing the solvent from the composition, the viewpoint of softening the adhesive coating layer to realize suitable bonding with the release agent coating layer, and the like. In particular, from the viewpoint of suppressing or avoiding excessive curing and unnecessary alteration of the adhesive component (A), the heating temperature is preferably 130°C or lower, more preferably 90°C or lower, and the heating time is appropriately determined according to the heating temperature and the type of the adhesive. However, from the viewpoint of reliably exhibiting suitable adhesion, the heating time is ordinarily 30 seconds or longer, and preferably 1 minute or longer. From the viewpoint of suppressing alteration of the adhesion layer and other members, the heating time is ordinarily 10 minutes or shorter, and preferably 5 minutes or shorter.

In the decompression treatment, the adhesive coating layer and the release agent coating layer which are in contact with each other may be exposed to an atmospheric pressure of 10 to 10,000 Pa. The time for the decompression treatment is ordinarily 1 to 30 minutes.

From the viewpoint of obtaining a laminate in which the substrate can be satisfactorily separated with good reproducibility, the two layers in contact with each other are bonded to each other preferably by decompression treatment, more preferably by combined use of heat treatment and decompression treatment.

The load in the thickness direction of the semiconductor substrate and the support substrate is not particularly limited as long as the load does not adversely affect the semiconductor substrate, the support substrate, and the two layers therebetween, and can make the substrates and the layers stick together. Ordinarily, the load is within a range of 10 to 1000 N.

The temperature of the post-heating is preferably 120°C or higher from the viewpoint of achieving a sufficient curing rate and the like, and is preferably 260°C or lower from the viewpoint of preventing alteration of the substrate and each layer, and the like.

The post-heating time is ordinarily 1 minute or more, preferably 5 minutes or more from the viewpoint of achieving suitable bonding of the substrate and the layer constituting the laminate, and is ordinarily 180 minutes or less, preferably 120 minutes or less from the viewpoint of suppressing or avoiding an adverse effect on each layer due to excessive heating, and the like.

The heating can be performed using a hot plate, an oven, or the like. When post-heating is performed using a hot plate, heating may be performed with either the semiconductor substrate or the support substrate of the laminate facing downward, but it is preferable to perform post-heating with the semiconductor substrate facing downward from the viewpoint of achieving suitable release with good reproducibility.

Note that one object of the post-heat treatment is to achieve an adhesion layer and a release agent layer which are more suitable self-standing films, particularly to suitably achieve curing by a hydrosilylation reaction.

### <Second embodiment>

The laminate having the electronic device layer is used for processing the electronic device layer. While the electronic device layer is subjected to processing, the electronic device layer is adhered to the support substrate via the adhesion layer. After processing the electronic device layer, the release agent layer is irradiated with light, and then the electronic device layer is separated from the support substrate.

### <<Electronic device layer>>

The electronic device layer refers to a layer having an electronic device, and in the present invention, refers to a layer in which a plurality of semiconductor chip substrates are embedded in a sealing resin, that is, a layer including a plurality of semiconductor chip substrates and a sealing resin disposed between the semiconductor chip substrates.

Here, the "electronic device" means a member constituting at least a part of an electronic component. The electronic device is not particularly limited, and can be one in which various mechanical structures and circuits are formed on the surface of a semiconductor substrate. The electronic device is preferably a complex of a member made of metal or a semiconductor and a resin that seals or insulates the member. The electronic device may be one in which a redistribution layer, which will be described later, and/or a semiconductor element or other elements are sealed or insulated with a sealing material or an insulating material, and has a single-layer or multi-layer structure.

### <<Support substrate>>

As the support substrate, those similar to those described in the section of <<Support substrate>> above of <First embodiment> above are exemplified.

### <<Release agent layer>>

The release agent layer is formed using the adhesive composition for light irradiation release of the present invention described above.

The detailed description of the release agent layer is as described in the section of <<Release agent layer>> above of <First embodiment> above.

### <<Adhesion layer>>

The adhesion layer is formed using the adhesive composition described above.

The detailed description of the adhesion layer is as described in the section of <<Adhesion layer>> above of <First embodiment> above.

Hereinafter, an example of the configuration of the laminate of the second embodiment will be described with reference to the drawings.

Fig. 2 shows a schematic cross-sectional view of an example of the laminate of the second embodiment.

The laminate of Fig. 2 includes the support substrate 24, the release agent layer 23, the adhesion layer 22, and the electronic device layer 26 in this order.

The electronic device layer 26 includes a plurality of semiconductor chip substrates 21 and a sealing resin 25 which is a sealing material disposed between the semiconductor chip substrates 21.

The adhesion layer 22 and the release agent layer 23 are provided between the electronic device layer 26 and the support substrate 24. The adhesion layer 22 is in contact with the electronic device layer 26. The release agent layer 23 is in contact with the adhesion layer 22 and the support substrate 24.

### <<Method for producing one example of laminate in second embodiment>>

A method for producing a laminate will be described below with the laminate shown in Fig. 2 as an example of the laminate in the second embodiment.

The laminate of the present invention can be produced, for example, by a method including a first step of coating the surface of the support substrate with the release agent composition to form a release agent coating layer (if necessary, further heating is performed to form a release agent layer), a second step of coating the surface of the release agent coating layer or the release agent layer with the adhesive composition to form an adhesive coating layer (if necessary, further heating is performed to form an adhesion layer), a third step of placing a semiconductor chip substrate on the adhesive coating layer or the adhesion layer and bonding the semiconductor chip substrate to the adhesive coating layer or the adhesion layer while performing at least one of heat treatment and decompression treatment, a fourth step of curing the adhesive coating layer by a post-heat treatment to form an adhesion layer, and a fifth step of sealing the semiconductor chip substrate fixed onto the adhesion layer using a sealing resin.

Describing the third step in more detail, for example, there is the following step (i) of the embodiment.
(i) The semiconductor chip substrate is placed on the adhesive coating layer or the adhesion layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesion layer.

Furthermore, the step of forming the adhesion layer by post-heating and curing the adhesive coating layer defined in the fourth step may be performed after the semiconductor chip substrate in the third step is bonded to the adhesive coating layer, or may be performed together with the third step. For example, by placing the semiconductor chip substrate on the adhesive coating layer and heating and curing the adhesive coating layer while applying a load in the thickness direction of the semiconductor chip substrate and the support substrate, close contact between the semiconductor chip substrate and the adhesive coating layer and curing from the adhesive coating layer to the adhesion layer may be performed together, and the adhesion layer and the semiconductor chip substrate may be bonded to each other.

In addition, the step of forming the adhesion layer by post-heating and curing the adhesive coating layer defined in the fourth step may be performed before the third step, or the adhesion layer and the semiconductor chip substrate may be bonded to each other while the semiconductor chip substrate is placed on the adhesion layer and a load in the thickness direction of the semiconductor chip substrate and the support substrate is applied.

The coating method, the heating temperature of the applied release agent composition or adhesive composition, the heating means, and the like are as described in

### <<Method for producing one example of laminate in first embodiment>> above of <First embodiment> above.

Hereinafter, the procedure of the method for producing the laminate of the second embodiment will be described in more detail with reference to the drawings.

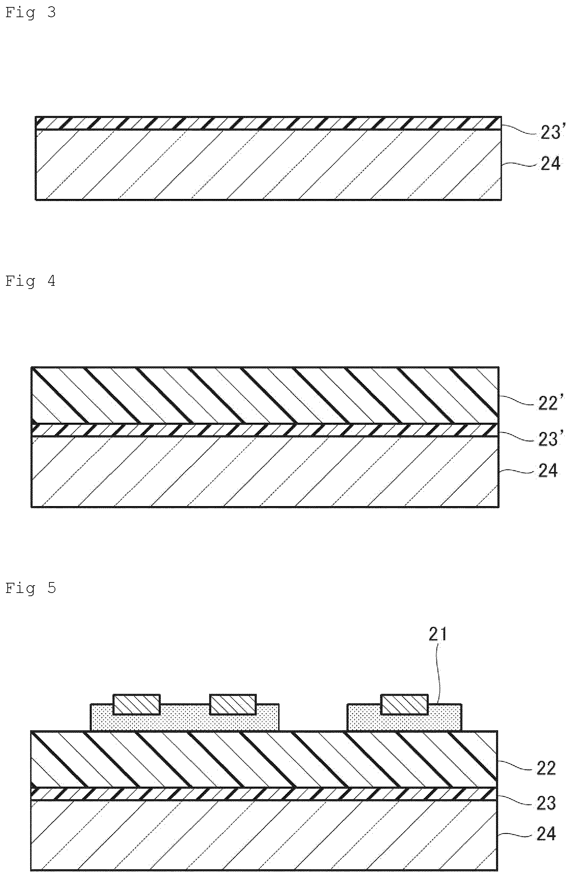

As shown in Fig. 3, a release agent coating layer 23' made of a release agent composition is formed on the support substrate 24. At that time, the release agent coating layer 23' may be heated to form a release agent layer 23.

Next, as shown in Fig. 4, an adhesive coating layer 22' made of an adhesive composition is formed on the release agent coating layer 23' or the release agent layer 23. At that time, the adhesive coating layer 22' may be heated to form an adhesion layer 22.

Next, as shown in Fig. 5, the semiconductor chip substrate 21 is placed on the adhesion layer 22 or the adhesive coating layer 22', the semiconductor chip substrate 21 and the adhesion layer 22 or the adhesive coating layer 22' are brought into close contact with each other by applying a load in the thickness direction of the semiconductor chip substrate 21 and the support substrate 24 while performing at least one of heat treatment and decompression treatment, and the semiconductor chip substrate 21 is bonded to the adhesion layer 22 or the adhesive coating layer 22'. When the semiconductor chip substrate 21 is bonded to the adhesive coating layer 22', the adhesive coating layer 22' is cured by post-heat treatment to form the adhesion layer 22, and the semiconductor chip substrate 21 is fixed to the adhesion layer 22.

Note that when the adhesive coating layer 22' is subjected to the post-heat treatment, the release agent coating layer 23' may also be subjected to the post-heat treatment to form the release agent layer 23.

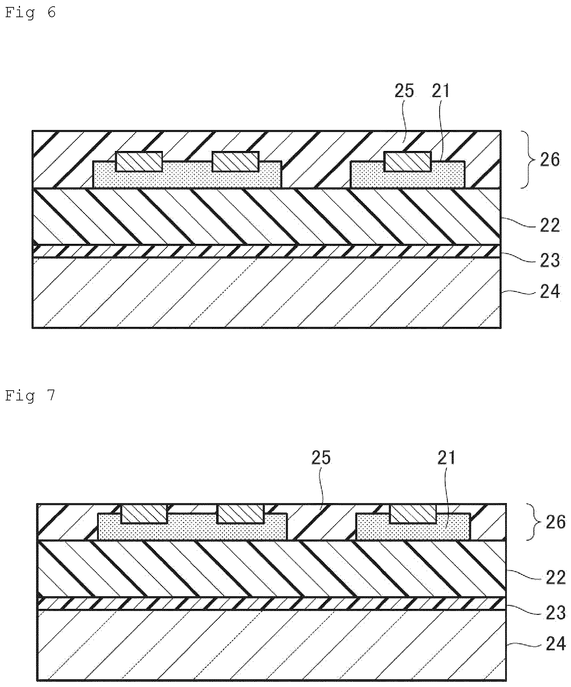

Subsequently, as shown in Fig. 6, the semiconductor chip substrate 21 fixed onto the adhesion layer 22 is sealed using the sealing resin 25. In Fig. 6, the plurality of semiconductor chip substrates 21 temporarily adhered onto the support substrate 24 via the adhesion layer 22 are sealed with the sealing resin 25. The electronic device layer 26, which includes the semiconductor chip substrate 21 and the sealing resin 25 disposed between the semiconductor chip substrates 21, is formed on the adhesion layer 22, and as described above, the electronic device layer 26 is a base material layer in which a plurality of semiconductor chip substrates are embedded in the sealing resin.

### <<<Sealing step>>>

The semiconductor chip substrate 21 is sealed using a sealing material.

As a sealing material for sealing the semiconductor chip substrate 21, a member capable of insulating or sealing a member made of metal or a semiconductor is used.

In the present invention, for example, a resin composition is used as the sealing material. The type of the sealing resin is not particularly limited as long as it can seal and/or insulate a metal or a semiconductor, but for example, an epoxy-based resin, a silicone-based resin, or the like is preferably used.

The sealing material may contain, in addition to the resin component, an additional component such as a filler. Examples of the filler include spherical silica particles.

In the sealing step, for example, the sealing resin heated to 130 to 170°C is supplied onto the adhesion layer 22 to cover the semiconductor chip substrate 21 while maintaining a high viscosity state, and is compression-molded to form a layer including the sealing resin 25 on the adhesion layer 22. At this time, the temperature condition is, for example, 130 to 170°C. In addition, the pressure applied to the semiconductor chip substrate 21 is, for example, 50 to 500 N/cm².

### (Method for producing processed semiconductor substrate or electronic device layer)

When the laminate according to the present invention is used, a method for producing a processed semiconductor substrate or a method for producing a processed electronic device layer can be provided.

In the "method for producing a processed semiconductor substrate", the laminate described in the section of <First embodiment> above of the (Laminate) above is used. In addition, in the "method for producing a processed electronic device layer", the laminate described in the section of <Second embodiment> above of the (Laminate) above is used.

A "method for producing a processed semiconductor substrate" will be described in <Third embodiment> below, and a "method for producing a processed electronic device layer" will be described in <Fourth embodiment> below.

### <Third embodiment>

The method for producing a processed semiconductor substrate of the present invention includes the following step 5A and the following step 6A.

Here, the step 5A is a step of processing the semiconductor substrate in the laminate described in the section of <First embodiment> above.

In addition, Step 6A is a step of separating the semiconductor substrate processed in Step 5A and the support substrate from each other.

The processing performed on the semiconductor substrate in Step 5A is, for example, processing on the side opposite to the circuit surface of the wafer, and includes thinning of the wafer by polishing the back surface of the wafer. Thereafter, for example, a through-silicon via (TSV) or the like is formed, and then the thinned wafer is released from the support substrate to form a laminate of wafers which are three-dimensionally mounted. In addition, for example, before and after that, a wafer back surface electrode and the like are also formed. Heat of approximately 250 to 350°C is applied to thinning of a wafer and a TSV process in a state of being adhered to the support substrate. The laminate of the present invention ordinarily includes the adhesion layer to provide heat resistance to the load.

Note that the processing is not limited to the above-described processing, and includes, for example, implementation of a process of mounting a semiconductor component in a case where the semiconductor component is temporarily adhered to the support substrate in order to support a base material for mounting the semiconductor component.

In Step 6A, examples of the method for separating (releasing) the semiconductor substrate and the support substrate include, but are not limited to, a method for mechanical release with equipment having a sharp portion, a releasing method for separation between the support and the semiconductor wafer, and the like after the light irradiation to the release agent layer.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesion layer, the thickness of the adhesion layer, the thickness of the release agent layer, the intensity of light to be emitted, and the like, but those skilled in the art can appropriately set conditions without requiring an excessive test. For such circumstances, according to the method for producing a processed semiconductor substrate of the present invention, for example, in a case where the support substrate of the laminate to be used is light-transmissive, it is possible to shorten the irradiation time with light when release is performed by light irradiation from the support substrate side, and as a result, not only improvement in throughput can be expected, but also physical stress and the like required for release can be avoided, and the semiconductor substrate and the support substrate can be easily and efficiently separated from each other only by light irradiation.

The irradiation level of light required for release is ordinarily 50 to 3,000 mJ/cm². The irradiation time is appropriately determined depending on the wavelength and the irradiation level.

The wavelength of light used for release is preferably, for example, a wavelength of 250 to 600 nm, more preferably a wavelength of 250 to 370 nm. The wavelength is more suitably 254 nm, 308 nm, 343 nm, 355 nm, 365 nm, or 532 nm, particularly preferably 254 nm or 365 nm. The irradiation level required for release is a dose capable of causing suitable alteration, for example, decomposition of a specific light-absorbing compound.

The light used for release may be laser light or non-laser light emitted from a light source such as an ultraviolet lamp. In the present invention, non-laser light emitted from a light source such as an ultraviolet lamp is preferably used.

The substrate can be cleaned by spraying a cleaning agent composition onto the surface of at least one of the separated semiconductor substrate and the support substrate, or immersing the separated semiconductor substrate or the support substrate in a cleaning agent composition.

In addition, the surface of the processed semiconductor substrate or the like may be cleaned using a removal tape or the like.

The constituent elements and method elements related to the above-described steps of the method for producing a processed semiconductor substrate of the present invention may be variously changed without departing from the gist of the present invention.

The method for producing a processed semiconductor substrate of the present invention may include steps other than the above-described steps.

In the releasing method of the present invention, when the semiconductor substrate or the support substrate of the laminate of the present invention has light transmittivity, the semiconductor substrate and the support substrate of the laminate are separated from each other by irradiating the release agent layer with light from the semiconductor substrate side or the support substrate side.

In the laminate of the present invention, the semiconductor substrate and the support substrate are temporarily adhered to each other by the adhesion layer and the release agent layer to be suitably releasable, and thus, for example, when the support substrate has light transmittivity, the semiconductor substrate and the support substrate can be easily separated from each other by irradiating the release agent layer with light from the support substrate side of the laminate. Ordinarily, release is performed after the semiconductor substrate of the laminate is processed.

### <Fourth embodiment>

The method for producing a processed electronic device layer of the present invention includes the following step 5B and the following step 6B.

Here, the step 5B is a step of processing the electronic device layer in the laminate described in the section of <Second embodiment> above.

In addition, Step 6B is a step of separating the electronic device layer processed in Step 5B from the support substrate.

Examples of the processing performed on the electronic device layer in Step 5B include a grinding step and a wiring layer forming step.

### <<Grinding step>>

The grinding step is a step of grinding the resin part of the layer of the sealing resin 25 in the electronic device layer 26 such that a part of the semiconductor chip substrate 21 is exposed after the sealing step.

The grinding of the sealing resin portion is performed, for example, by grinding the layer of the sealing resin 25 to a thickness substantially equal to that of the semiconductor chip substrate 21 as shown in Fig. 7.

### <<Wiring layer forming step>>

The wiring layer forming step is a step of forming a wiring layer on the exposed semiconductor chip substrate 21 after the grinding step.

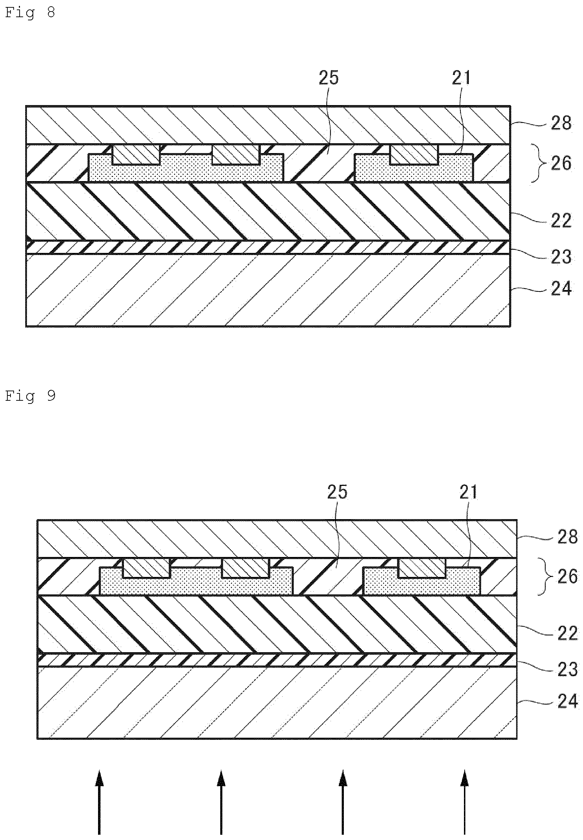

In Fig. 8, a wiring layer 28 is formed on the electronic device layer 26 including the semiconductor chip substrate 21 and the layer of the sealing resin 25.

The wiring layer 28 is also called a redistribution layer (RDL), is a thin-film wiring body constituting wiring connected to a substrate, and may have a single-layer or multi-layer structure. The wiring layer may be one in which wiring is formed by a conductor (for example, metals such as aluminum, copper, titanium, nickel, gold, and silver, and alloys such as silver-tin alloys) between dielectrics (photosensitive resin such as silicon oxide (SiO_{X}) and photosensitive epoxy), but is not limited thereto.

Examples of the method for forming the wiring layer 28 include the following methods.

First, a dielectric layer of silicon oxide (SiO_{X}), a photosensitive resin, or the like is formed on the layer of the sealing resin 25. The dielectric layer made of silicon oxide can be formed by, for example, a sputtering method, a vacuum vapor deposition method, or the like. The dielectric layer made of a photosensitive resin can be formed by coating the layer of the sealing resin 25 with a photosensitive resin by a method such as spin coating, dipping, roller blade, spray coating, or slit coating.

Subsequently, wiring is formed on the dielectric layer with a conductor such as metal. As a method for forming the wiring, for example, a known semiconductor process approach such as lithography processing such as photolithography (resist lithography) or etching processing can be used. Examples of such lithography processing include lithography processing using a positive resist material and lithography processing using a negative resist material.

In the method for producing a laminate according to a fourth embodiment, a bump can be further formed or an element can be mounted on the wiring layer 28. The element can be mounted on the wiring layer 28 using, for example, a chip mounter or the like.

The laminate according to the fourth embodiment may be a laminate prepared in a process based on a fan-out type technology in which a terminal provided on a semiconductor chip substrate is mounted on a wiring layer extending outside a chip area.

In Step 6B, examples of the method for separating (releasing) the electronic device layer and the support substrate include, but are not limited to, a method for mechanical releasing with equipment having a sharp portion, a releasing method for separation between the support and the electronic device layer, and the like after the light irradiation to the release agent layer.

By irradiating the release agent layer with light from the support substrate side, the release agent layer is altered (for example, the release agent layer is separated or decomposed) as described above, and thereafter, for example, one of the substrates is pulled up, and the electronic device layer and the support substrate can be easily separated from each other.

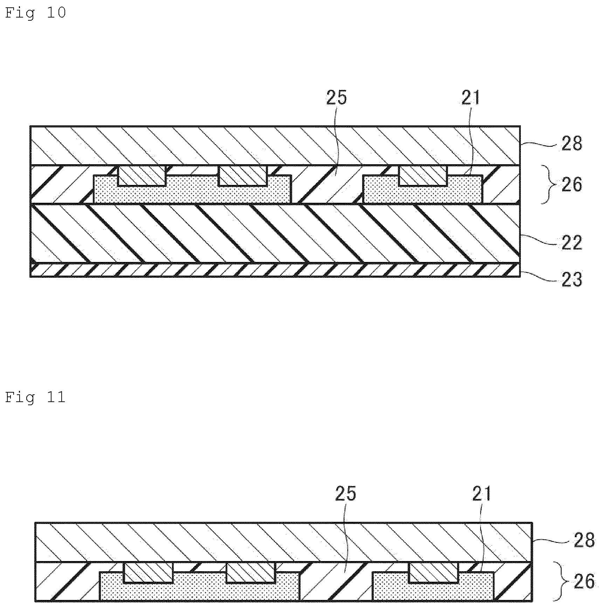

Figs. 9 and 10 are schematic cross-sectional views for explaining a method for separating the laminate, and Fig. 11 is a schematic cross-sectional view for explaining a cleaning method after the separation of the laminate. An embodiment of a method for producing a semiconductor package (electronic component) can be described with reference to Figs. 9 to 11.

As shown in Fig. 9, the step of separating the laminate is a step of separating the electronic device layer 26 and the support substrate 24 by irradiating the release agent layer 23 with light (arrow) through the support substrate 24 to alter the release agent layer 23.

After irradiating the release agent layer 23 with light (arrow) to alter the release agent layer 23, the support substrate 24 is separated from the electronic device layer 26 as shown in Fig. 10.

The irradiation conditions, irradiation methods, and the like of irradiation of the adhesion layer with light are as described in the section of <Third embodiment> above.

The substrate can be cleaned by spraying the cleaning agent composition onto the surface of at least one of the separated electronic device layer and the support substrate, or immersing the separated electronic device layer or the support substrate in the cleaning agent composition.

In addition, the surface of the processed electronic device layer or the like may be cleaned using a removal tape or the like.

For example, in Fig. 10, the adhesion layer 22 and the release agent layer 23 are attached to the electronic device layer 26 after the separation step, but the adhesion layer 22 and the release agent layer 23 can be removed by decomposing the adhesion layer 22 and the release agent layer 23 using a cleaning agent composition such as acid or alkali. By removing the release agent layer and the adhesion layer, a processed electronic device layer (electronic component) as shown in Fig. 11 can be suitably obtained.

The constituent elements and method elements related to the above-described steps of the method for producing a processed electronic device layer of the present invention may be variously changed without departing from the gist of the present invention.

The method for producing a processed electronic device layer of the present invention may include steps other than the above-described steps.

In the laminate of the present invention, since the electronic device layer and the support substrate are temporarily adhered to each other by the adhesion layer to be suitably releasable, for example, when the support substrate is light-transmissive, the electronic device layer and the support substrate can be easily separated from each other by irradiating the release agent layer with light from the support substrate side of the laminate. Ordinarily, release is performed after the electronic device layer of the laminate is processed.

### Examples

Hereinafter, the present invention will be more specifically described with reference to examples, but the present invention is not limited to the following examples. Note that the apparatus used is as follows.

### [Apparatus]

(1) Vacuum bonding apparatus: manual bonder manufactured by SUSS MicroTec
(2) UV irradiation device (at 254 nm): QRU-2374 manufactured by ORC MANUFACTURING CO., LTD.
(3) UV irradiation device (at 365 nm): UVI-MA manufactured by OHMIYA IND. CO., LTD.

### [1] Preparation of adhesive composition

### [Preparation Example 1]

In a 600 mL stirring vessel dedicated to a stirrer, 80 g of an MQ resin (manufactured by Wacker Chemie AG) containing a polysiloxane and a vinyl group as a polyorganosiloxane (a1), 2.52 g of a SiH group-containing linear polydimethylsiloxane (manufactured by Wacker Chemie AG) having a viscosity of 100 mPa·s as a polyorganosiloxane (a2), 5.89 g of a SiH group-containing linear polydimethylsiloxane (manufactured by Wacker Chemie AG) having a viscosity of 70 mPa·s as a polyorganosiloxane (a2), and 0.22 g of 1-ethynylcyclohexanol (manufactured by Wacker Chemie AG) as a polymerization inhibitor (A3) were placed and stirred with a stirrer for 5 minutes.

To the resulting mixture, 3.96 g of a mixture obtained by stirring 0.147 g of a platinum catalyst (manufactured by Wacker Chemie AG) as a platinum group metal-based catalyst (A2) and 5.81 g of a vinyl group-containing linear polydimethylsiloxane (manufactured by Wacker Chemie AG) having a viscosity of 1,000 mPa·s as a polyorganosiloxane (a1) with a stirrer for 5 minutes was added, followed by stirring with a stirrer for 5 minutes.

Finally, the resulting mixture was filtered through a nylon filter 300 mesh to obtain the adhesive composition (A). The viscosity of the adhesive measured with a viscometer was 10,000 mPa·s.

### [2] Synthesis of nitrobenzene derivative polymer

### [Synthesis Example 1]

A flask was charged with 11.0 g of a polyglycidyl methacrylate polymer, 5.4 g of 3-methyl-2-nitrobenzoic acid, 0.2 g of tetrabutylphosphonium bromide as a catalyst, 33.6 g of propylene glycol monomethyl ether acetate as a solvent, and 41. g of 1-methoxy-2-propanol, followed by stirring. Thereafter, the obtained mixture was reacted at 105°C for 24 hours.

The reaction mixture was cooled to room temperature to then obtain a composition containing a target nitrobenzene derivative polymer represented by the following Formula (5-1-1).

The polyglycidyl methacrylate polymer used this time was dissolved in propylene glycol monomethyl ether acetate so as to be 32.2% parts by mass, and the epoxy value at that time was 6.2 mol/kg.

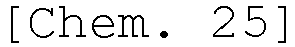

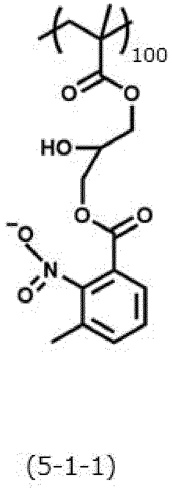

### [3] Synthesis of oxime ester derivative polymer

### [Synthesis Example 2]

A flask was charged with 5.0 g of acetophenone oxime, 5.8 g of 4-vinylbenzoic acid, 9.7 g of 1-ethyl-3-(3-dimethylaminopropyl)carbodiimide hydrochloride, 1.0 g of 4-dimethylaminopyridine, and 42.8 g of tetrahydrofuran as a solvent, and the obtained mixture was stirred at room temperature for 24 hours.

The reaction mixture was extracted into an organic layer using ethyl acetate and water. The organic layer after extraction was dried under reduced pressure to obtain a desired compound.

A flask was charged with 15.0 g of the resulting compound, 0.4 g of azobisisobutyronitrile as a radical polymerization initiator, and 36.0 g of propylene glycol monomethyl ether acetate as a solvent, followed by stirring. Thereafter, the obtained mixture was reacted overnight at 60°C.

The reaction mixture was cooled to room temperature to then obtain a composition containing a target oxime ester derivative polymer represented by the following Formula (5-2-1).

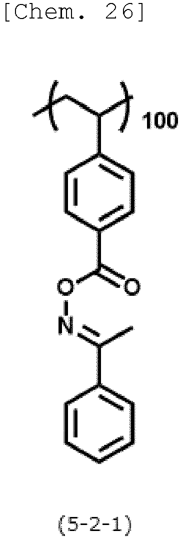

### [4] Synthesis of aromatic azide derivative polymer

### [Synthesis Example 3]

A flask was charged with 10.0 g of a polyglycidyl methacrylate polymer, 3.7 g of 4-azidobenzoic acid, 0.4 g of tetrabutylphosphonium bromide as a catalyst, 25.1 g of propylene glycol monomethyl ether acetate as a solvent, and 31.8 g of 1-methoxy -2 propanol, followed by stirring. Thereafter, the obtained mixture was reacted at 105°C for 24 hours.

The reaction mixture was cooled to room temperature to then obtain a composition containing a target aromatic azide derivative polymer represented by the following Formula (5-3-1).

The polyglycidyl methacrylate polymer used this time was dissolved in propylene glycol monomethyl ether acetate so as to be 32.2% parts by mass, and the epoxy value at that time was 6.2 mol/kg.

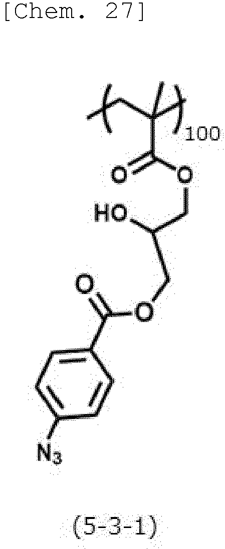

### [5] Preparation of release agent composition

### [Example 1-1]

The nitrobenzene derivative polymer obtained in Synthesis Example 1 was dissolved in propylene glycol monomethyl ether acetate so as to be 18.4 mass% to prepare a solution, thereby obtaining a release agent composition.

### [Example 1-2]

The oxime ester derivative polymer obtained in Synthesis Example 2 was dissolved in propylene glycol monomethyl ether acetate so as to be 20 mass% to prepare a solution, thereby obtaining a release agent composition.

### [Example 1-3]

The aromatic azide derivative obtained in Synthesis Example 3 was dissolved in propylene glycol monomethyl ether acetate so as to be 10 mass% to prepare a solution, thereby obtaining a release agent composition.

### [Example 1-4]

2.0 g of polyacrylic acid, 1.0 g of sodium 1,2-naphthoquinone-2-diazide-4-sulfonate represented by the following Formula (4-2), 13.5 g of propylene glycol monomethyl ether acetate as a solvent, and 13.5 g of 1-methoxy-2-propanol were charged and stirred to obtain a release agent composition.

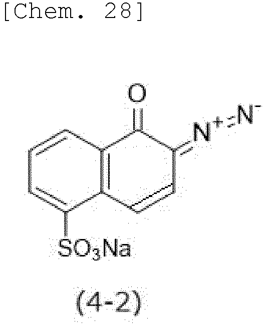

### [6] Production of laminate

### [Example 2-1]

The release agent composition obtained in Example 1-1 was spin-coated on a 100 mm glass wafer such that the film thickness in the finally obtained laminate was about 3.0 µm, and heated at 100°C for 1 minute to form a release agent coating layer on a glass wafer as a support substrate.

Meanwhile, the adhesive composition obtained in Preparation Example 1 was spin-coated on a 100 mm silicon wafer such that the film thickness in the finally obtained laminate was about 60 µm to form an adhesive coating layer on the silicon wafer: a semiconductor substrate.

Then, the vacuum bonding apparatus was used to bond the glass wafer and the silicon wafer so as to sandwich the release agent coating layer and the adhesive coating layer, followed by post-heating at 150°C for 10 minutes to form a laminate. Bonding was performed at a temperature of 23°C and a degree of pressure reduction was 1,500 Pa. Note that as many laminates as necessary were produced.

### [Examples 2-2 to 2-3]

A laminate was formed in the same manner as in Example 2-1, except that the release agent compositions obtained in Examples 1-2 to 1-3 were used instead of the release agent composition obtained in Example 1-1.

### [Example 2-4]

The release agent composition obtained in Example 1-4 was spin-coated on a 100 mm glass wafer such that the film thickness in the finally obtained laminate was about 5.0 µm, and heated at 100°C for 1 minute to form a release agent coating layer on a glass wafer as a support substrate.

Meanwhile, the adhesive composition obtained in Preparation Example 1 was spin-coated on a 100 mm silicon wafer such that the film thickness in the finally obtained laminate was about 60 µm to form an adhesive coating layer on the silicon wafer: a semiconductor substrate.

Then, the vacuum bonding apparatus was used to bond the glass wafer and the silicon wafer so as to sandwich the release agent coating layer and the adhesive coating layer, followed by post-heating at 100°C for 15 minutes to form a laminate. Bonding was performed at a temperature of 23°C and a degree of pressure reduction was 1,500 Pa. Note that as many laminates as necessary were produced.

### [7] Confirmation of optimum irradiation level of 254 nm UV light and 365 nm UV light

In the laminate obtained in each of Examples 2-1 to 2-4, 254 nm UV light was emitted from the glass wafer side to the entire surface of the wafer using a UV irradiation device, and the minimum UV irradiation output at which release occurred in a range of an output of 100 to 30,000 mJ/cm² was confirmed, and this was defined as the optimum irradiation level. As a result, the optimum irradiation level in 254 nm UV light was 20,000 mJ/cm².

In the laminate obtained in each of Examples 2-1 to 2-4, 365 nm UV light was emitted from the glass wafer side to the entire surface of the wafer using a UV irradiation device, and the minimum UV irradiation output at which release occurred in a range of an output of 500 to 30,000 mJ/cm² was confirmed, and this was defined as the optimum irradiation level. As a result, the optimum irradiation level in 365 nm UV light was 20,000 mJ/cm².

### [8] Confirmation of releasability by 254 nm UV light and 365 nm UV light (confirmation of release by whole surface irradiation)

### [Example 3-1]

In the laminate obtained in Example 2-1, UV light was emitted from the glass wafer side to the entire surface of the wafer using a UV irradiation device. After UV irradiation, it was confirmed whether or not the glass wafer could be released. At this time, the UV output was set to the optimum irradiation level: 20,000 mJ/cm².

As a result, it was confirmed that the glass wafer (carrier side) could be easily released manually in the case of irradiation with 254 nm UV light.

However, when the UV light was 365 nm, the glass wafer could not be released.

### [Example 3-2]

In the laminate obtained in Example 2-2, UV light was emitted from the glass wafer side to the entire surface of the wafer using a UV irradiation device. After UV irradiation, it was confirmed whether or not the glass wafer could be released. At this time, the UV output was set to the optimum irradiation level: 20,000 mJ/cm².

As a result, it was confirmed that the glass wafer (carrier side) could be easily released manually in the case of irradiation with 254 nm UV light.

However, when the UV light was 365 nm, the glass wafer could not be released.

### [Example 3-3]

In the laminate obtained in Example 2-3, UV light was emitted from the glass wafer side to the entire surface of the wafer using a UV irradiation device. After UV irradiation, it was confirmed whether or not the glass wafer could be released. At this time, the UV output was set to the optimum irradiation level: 20,000 mJ/cm².

As a result, it was confirmed that the glass wafer (carrier side) could be easily released manually in the case of irradiation with 254 nm UV light.

However, when the UV light was 365 nm, the glass wafer could not be released.

### [Example 3-4]

In the laminate obtained in Example 2-4, UV light was emitted from the glass wafer side to the entire surface of the wafer using a UV irradiation device. After UV irradiation, it was confirmed whether or not the glass wafer could be released. At this time, the UV output was set to the optimum irradiation level: 20,000 mJ/cm².

As a result, it was confirmed that the glass wafer (carrier side) could be easily released manually in the case of irradiation with 254 nm UV light.

In addition, it was confirmed that the glass wafer (carrier side) could be easily released manually also in the case of irradiation with 254 nm UV light.

From the above Examples, it has been confirmed that the composition layer formed using the release agent composition for light irradiation release defined in the present invention is favorably released by UV irradiation as long as a desired wavelength is selected, although it is necessary to appropriately select a suitable wavelength.

Regarding the release agent composition for light irradiation release as defined in the present invention, it is possible to provide a release agent composition for forming a release agent layer that can be released by light irradiation and is used for a laminate, in the laminate in which a support substrate and a semiconductor substrate or an electronic device layer can be firmly adhered to each other during processing of the semiconductor substrate or the electronic device layer, and the support substrate and the semiconductor substrate or the electronic device layer can be easily separated from each other by light irradiation after the substrate processing, the release agent composition being capable of easily releasing the semiconductor substrate or the electronic device layer from the support substrate only by light irradiation even without heating after light irradiation.

### Reference Signs List

- 1: Semiconductor substrate
- 2: Adhesion layer
- 3: Release agent layer
- 4: Support substrate
- 5: Release agent layer having adhesive performance
- 21: Semiconductor chip substrate
- 22: Adhesion layer
- 23: Release agent layer
- 24: Support substrate
- 25: Sealing resin
- 26: Electronic device layer
- 27: Release agent layer having adhesive performance
- 28: Wiring layer

## Claims

1. A release agent composition for light irradiation release for forming a release agent layer of a laminate which includes
a semiconductor substrate or an electronic device layer,
a light-transmissive support substrate, and
an adhesion layer and a release agent layer provided between the semiconductor substrate or the electronic device layer and the support substrate,
wherein the electronic device layer includes a plurality of semiconductor chip substrates and a sealing resin disposed between the semiconductor chip substrates, and
which is used for releasing the semiconductor substrate or the electronic device layer from the support substrate after the release agent layer absorbs light emitted from the support substrate side,
wherein the release agent composition is:
(i) a composition containing a polymer including a light-sensitive gas generating moiety that generates gas due to a chemical reaction by receiving the light; or
(ii) a composition containing a compound including a light-sensitive gas generating moiety that generates gas due to a chemical reaction by receiving the light and a polymer.

2. The release agent composition according to claim 1, wherein the light-sensitive gas generating moiety has a structure selected from the group consisting of a nitrobenzene-based structure, an oxime ester-based structure, an azide-based structure, a diazonium-based structure, a ketoprofen-based structure, a diazonaphthoquinone-based structure, an azo-based structure, an azobis-based structure, a sulfohydrazide-based structure, a hydrazo-based structure, a benzoin carbamate-based structure, a 1,2,3-thiazole-based structure, and a diazomethanesulfonic acid-based structure.

3. The release agent composition according to claim 1, wherein the polymer containing the light-sensitive gas generating moiety is a polymer having a repeating unit represented by the following Formula (1): 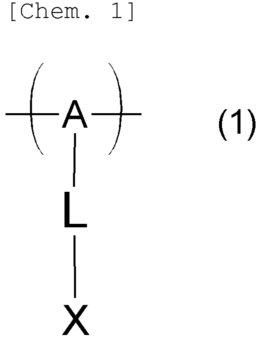 wherein in Formula (1), A represents a trivalent hydrocarbon group, L represents a linking group, and X represents a light-sensitive gas generating moiety.

4. The release agent composition according to claim 3, wherein Formula (1) above is a repeating unit represented by any one of the following Formulae (2-1) to (2-3), and the linking group of L is at least one of a single bond, -CO-, -COO-, an alkyl group optionally having a substituent, or -NH-: 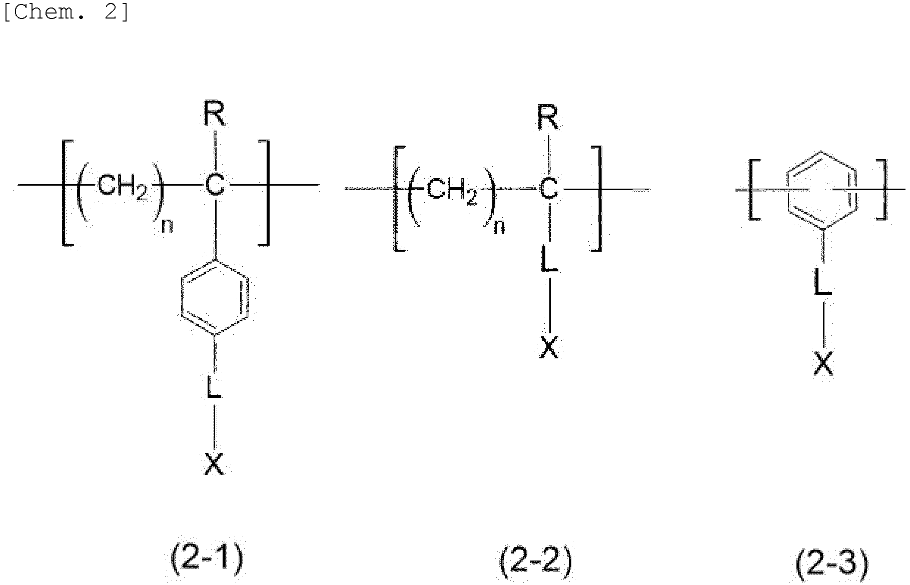 wherein in Formulae (2-1) to (2-3), R represents a hydrogen bond or a methyl group, X represents a light-sensitive gas generating moiety, and n represents an integer of 0 or 1.

5. The release agent composition according to claim 3, wherein in Formula (1) above, the light-sensitive gas generating moiety of X is represented by any one of the following Formulae (3-1) to (3-8): 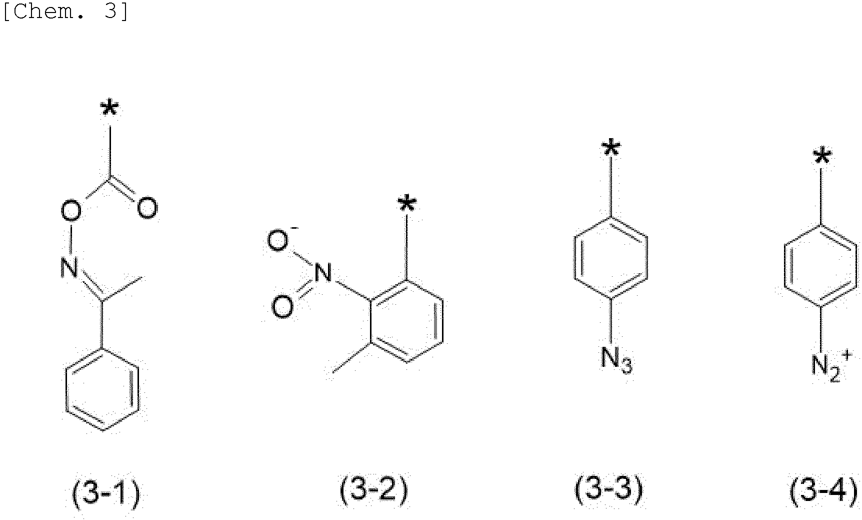 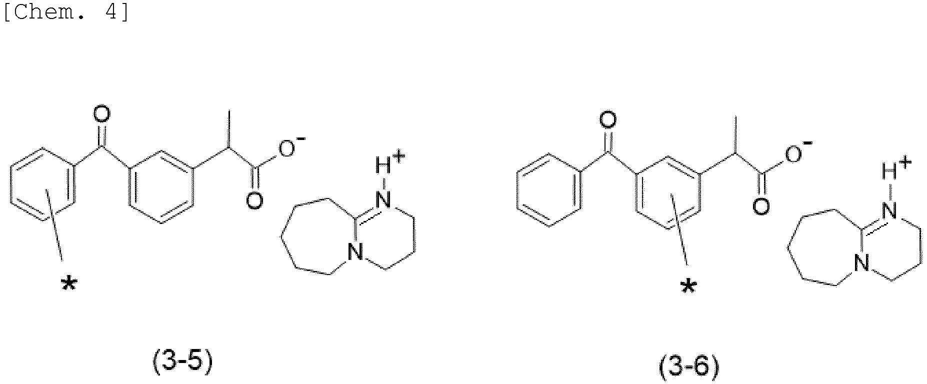 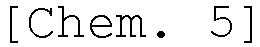 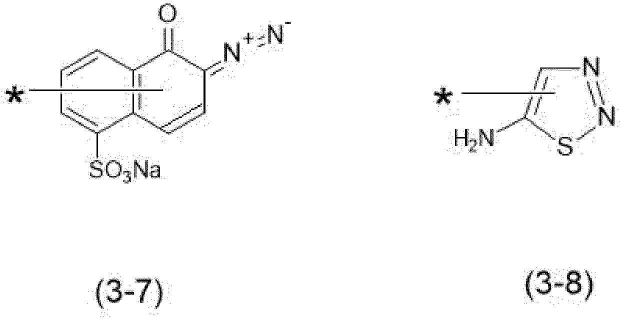 wherein in Formulae (3-1) to (3-8), * represents a bonding hand.

6. The release agent composition according to claim 1, wherein the compound containing a light-sensitive gas generating moiety has a compound represented by any one of the following Formulae (4-1) to (4-4):

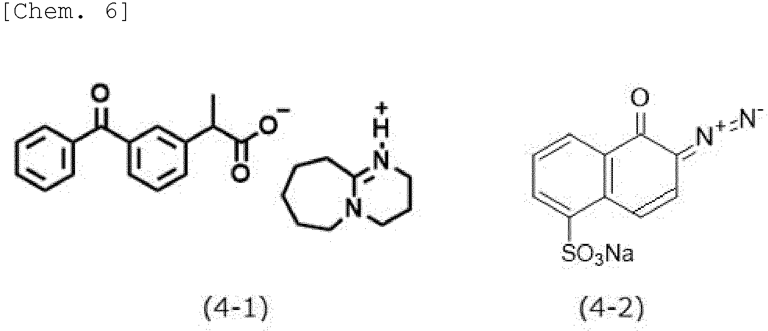

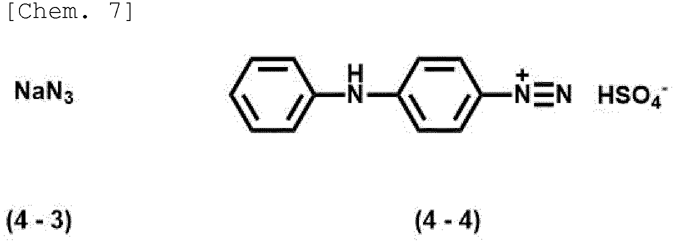

7. A laminate, comprising:
a semiconductor substrate or an electronic device layer;
a light-transmissive support substrate; and
an adhesion layer and a release agent layer which are provided between the semiconductor substrate or the electronic device layer and the support substrate,
wherein the electronic device layer includes a plurality of semiconductor chip substrates and a sealing resin disposed between the semiconductor chip substrates,
the release agent layer is used to release the semiconductor substrate or the electronic device layer and the support substrate after the release agent layer absorbs light emitted from the support substrate side, and
the release agent layer is formed from the release agent composition according to any one of claims 1 to 6.

8. A method for producing a processed semiconductor substrate or a processed electronic device layer, the method comprising:
Step 5A of processing the semiconductor substrate of the laminate according to claim 7, or Step 5B of processing the electronic device layer of the laminate according to claim 7; and
Step 6A of separating the semiconductor substrate processed in the Step 5A and the support substrate from each other, or Step 6B of separating the electronic device layer processed in the Step 5B and the support substrate from each other.

9. The method for producing a processed semiconductor substrate or a processed electronic device layer according to claim 8, wherein the Step 6A or the Step 6B includes a step of irradiating the laminate with UV light from the support substrate side.
